# EUROPEAN PATENT APPLICATION

(11) **EP 4 311 391 A1**
(43) Date of publication of application: **24.01.2024**
(21) Application number: 23185382.1
(22) Date of filing: 13.07.2023
(51) Int. Cl.: H10K 59/122, H10K 59/124

(54) **DISPLAY DEVICE AND METHOD OF PROVIDING THE SAME**

(30) Priority: 15.07.2022 KR 20220087849
(71) Applicant: Samsung Display Co., Ltd., Yongin-si, Gyeonggi-do 17113 (KR)
(72) Inventor: CHO, Hyun Min, Yongin-si (KR); KIM, Tae Sung, Yongin-si (KR); LEE, Kyong Chol, Yongin-si (KR)
(74) Representative: Marks & Clerk LLP

(57) **Abstract**

A display device includes a circuit array layer including first and second organic insulating layers on a pixel driving circuit, and a light emitting array layer including an organic insulating material pixel defining layer and a cathode electrode on the organic insulating material pixel defining layer A layer among the first organic insulating material planarization layer, the second organic insulating material planarization layer and the organic insulating material pixel defining layer includes a gas blocking thickness portion which extends from a surface of the layer which is closest to the cathode electrode.

## Description

### BACKGROUND

### 1. Field

The present disclosure relates to a display device and a method for manufacturing (or providing) the same.

### 2. Description of the Related Art

With the advance of an information-oriented society, more and more demands are placed on display devices for displaying images in various ways. For example, display devices are employed in various electronic devices such as smartphones, digital cameras, laptop computers, navigation devices, and smart televisions.

The display device may be a flat panel display device such as a liquid crystal display device, a field emission display device and a light emitting display device. Examples of the light emitting display device may include an organic light emitting display device including organic light emitting elements, an inorganic light emitting display device including inorganic light emitting elements such as inorganic semiconductors, and a micro light emitting display device including micro light emitting elements.

The organic light emitting display device displays an image using a plurality of light emitting elements, each including a light emitting layer made of an organic material. As described above, the organic light emitting display device implements image display using a self-light emitting element, and thus may have relatively superior performance in power consumption, response speed, luminous efficiency, luminance, and wide viewing angle compared to other display devices.

### SUMMARY

The display device may include a circuit array layer for independently driving a plurality of light emitting elements. Further, the plurality of light emitting elements may be disposed on the circuit array layer. The circuit array layer may include a planarization layer made of an organic insulating material that may evenly cover conductive patterns. Due to the planarization layer, the influence of the stepped portion formed by the conductive patterns on the arrangement of the light emitting element may be reduced.

However, the organic insulating material forming the planarization layer may become a permeation path for oxygen or moisture, and also contain gas. Accordingly, the organic material or the metal material of the light emitting element may be rapidly oxidized by the exposure to the gas, oxygen, and moisture from the organic insulating material. In this case, the width of the emission area of each light emitting element is rapidly reduced, so that the lifespan of the display device is rapidly reduced.

Aspects of the present disclosure provide a display device that may have an increased lifespan by preventing or delaying exposure of an organic material or a metal material to gas, oxygen, and moisture from an organic insulating material, and a method for manufacturing the same.

According to an embodiment, a display device includes a substrate including a display area including a light emission area, and a non-emission area which is adjacent to the light emission area. A circuit array layer is on the substrate. The circuit array layer includes: a pixel driving circuit corresponding to the light emission area; a first planarization layer on the pixel driving circuit and including an organic insulating material; an anode connection electrode on the first planarization layer and connected to the pixel driving circuit; and a second planarization layer on the first planarization layer, on the anode connection electrode, and comprising an organic insulating material. The display device further includes a light emitting array layer on the circuit array layer. The light emitting array layer includes: an anode electrode on the second planarization layer, corresponding to the light emission area, and connected to the anode connection electrode; a pixel defining layer on the second planarization layer, corresponding to the non-emission area, overlapping an edge of the anode electrode, and comprising an organic insulating material; a light emitting layer on the anode electrode; and a cathode electrode on the pixel defining layer and the light emitting layer, and corresponding to the light emission area. A layer among the first planarization layer, the second planarization layer and the pixel defining layer includes a gas blocking thickness portion which extends from a surface of the layer which is closest to the cathode electrode.

The light emitting array layer may further include a first common layer between the anode electrode and the light emitting layer; and a second common layer between the light emitting layer and the cathode electrode.

The pixel defining layer may include the surface which is closest to the cathode electrode, and the gas blocking thickness portion is in contact with the second common layer.

The pixel defining layer may further include: a surface which is closest to the substrate, and oxygen within the gas blocking thickness portion is less than oxygen at the surface which is closest to the substrate.

The anode electrode may include a reflective metal material, and a transparent conductive material which is on the reflective metal material, and the second planarization layer may include the surface which is closest to the cathode electrode, and the gas blocking thickness portion which extends from the surface which is closest to the cathode electrode.

The anode connection electrode may be connected to the pixel driving circuit through a first anode contact hole penetrating the first planarization layer, the anode electrode may be connected to the anode connection electrode through a second anode contact hole penetrating the second planarization layer, and the gas blocking thickness portion may be in contact with the anode electrode.

The second planarization layer may further comprise a surface which is closest to the substrate, and oxygen within the gas blocking thickness portion is less than oxygen at the surface which is closest to the substrate.

The gas blocking thickness portion may be provided in plural including a first gas blocking thickness portion and a second gas blocking thickness portion. The second planarization layer may include a first surface which is closest to the cathode electrode, the first gas blocking thickness portion extending from the first surface, a second surface which is closest to the substrate, and oxygen within the first gas blocking thickness portion is less than oxygen at the second surface of the second planarization layer which is closest to the substrate, together with the pixel defining layer including: a third surface which is closest to the cathode electrode, the second gas blocking thickness portion extending from the third surface, a fourth surface which is closest to the substrate, and oxygen within the second gas blocking thickness portion is less than oxygen at the fourth surface of the pixel defining layer which is closest to the sub strate.

The second gas blocking thickness portion may be closer to the cathode electrode than the first gas blocking thickness portion, and a thickness of the second gas blocking thickness portion may be smaller than a thickness of the first gas blocking thickness portion.

The gas blocking thickness portion which may be provided in plural may further include a third gas blocking thickness portion, and the first planarization layer may include: a fifth surface which is closest to the cathode electrode, the third gas blocking thickness portion extending from the fifth surface, a sixth surface which is closest to the substrate, and oxygen within the third gas blocking thickness portion is less than oxygen at the sixth surface of the first planarization layer which is closest to the substrate.

The pixel driving circuit may include a transistor, the transistor comprising a semiconductor layer on the substrate, a gate electrode, and a gate insulating layer between the semiconductor layer and the gate electrode, and the pixel driving circuit may further include an interlayer insulating layer facing the substrate with the transistor therebetween.

The pixel driving circuit may include a first transistor and a second transistor. The first transistor may include a first semiconductor layer on the substrate and include a silicon semiconductor, a first gate electrode, and a first gate insulating layer between the first semiconductor layer and the first gate electrode. The second transistor may include a second semiconductor layer in a different layer than the first semiconductor layer and include an oxide semiconductor, a second gate electrode, and a second gate insulating layer between the second semiconductor layer and the second gate electrode. The first planarization layer may face the substrate, with each of the first and second semiconductor layers, the first and second gate electrodes and the first and second gate insulating layers therebetween.

The display area may further include: the light emission area provided in plural including a first emission area, a second emission area and a third emission area which emit different colors from each other; a plurality of pixels each including the first, second and third emission areas; and a boundary between adjacent pixels among the plurality of pixels, and the circuit array layer may further include: the second gate electrode furthest from the substrate among the first and second semiconductor layers, the first and second gate electrodes and the first and second gate insulating layers; a groove corresponding to the boundary between the adjacent pixels; an auxiliary planarization layer between the second gate electrode and the first planarization layer, the auxiliary planarization layer comprising an organic insulating material; and the auxiliary planarization layer extending from between the second gate electrode and the first planarization layer, into the groove, and contacting the substrate at the groove.

The auxiliary planarization layer may include the surface which is closest to the cathode electrode, and the gas blocking thickness portion which extends from the surface which is closest to the cathode electrode.

According to another embodiment, a display device includes a substrate including a display area in which a plurality of emission areas is arranged, a circuit array layer disposed on the substrate and including a plurality of pixel driving units respectively corresponding to the plurality of emission areas, and a light emitting array layer disposed on the circuit array layer. The circuit array layer includes a first planarization layer covering two or more transistors comprised in each of the plurality of pixel driving units and including an organic insulating material, a plurality of anode connection electrodes disposed on the first planarization layer and respectively connected to the plurality of pixel driving units, and a second planarization layer disposed on the first planarization layer, covering the plurality of anode connection electrodes, and including an organic insulating material. The light emitting array layer includes a plurality of anode electrodes disposed on the second planarization layer, respectively corresponding to the plurality of emission areas, and respectively connected to the plurality of anode connection electrodes, a pixel defining layer disposed on the second planarization layer, corresponding to a non-emission area being between the plurality of emission areas, covering an edge of each of the plurality of anode electrodes, and including an organic insulating material, a plurality of light emitting layers respectively disposed on the plurality of anode electrodes, and a cathode electrode disposed on the pixel defining layer and the plurality of light emitting layers and corresponding to the plurality of emission areas. At least one of the first planarization layer, the second planarization layer and the pixel defining layer includes a gas blocking surface disposed on a surface facing the cathode electrode.

The light emitting array layer may further include first common layers respectively disposed between the plurality of anode electrodes and the plurality of light emitting layers, and a second common layer disposed between the plurality of light emitting layers and the cathode electrode.

The gas blocking surface may be disposed on a surface of the pixel defining layer in contact with the second common layer.

The gas blocking surface may include less oxygen than a surface of the pixel defining layer in contact with the second planarization layer.

Each of the plurality of anode electrodes may include a stacked structure of a reflective metal material and a transparent conductive material covering the reflective metal material. The gas blocking surface may be disposed on a surface of the second planarization layer in contact with the plurality of anode electrodes and the pixel defining layer.

The plurality of anode connection electrodes may be respectively connected to the plurality of pixel driving units through a plurality of first anode contact holes penetrating at least the first planarization layer. The plurality of anode electrodes may be respectively connected to the plurality of anode connection electrodes through a plurality of second anode contact holes penetrating the second planarization layer. The gas blocking surface may be further disposed on a surface of the second planarization layer in contact with the plurality of anode contact holes.

The gas blocking surface may include less oxygen than a surface of the second planarization layer in contact with the first planarization layer.

The second planarization layer may include a first gas blocking surface disposed on a surface in contact with the plurality of anode electrodes and the pixel defining layer. The pixel defining layer may include a second gas blocking surface disposed on a surface in contact with the second common layer. The first gas blocking surface may include less oxygen than a surface of the second planarization layer in contact with the first planarization layer. The second gas blocking surface may include less oxygen than a surface of the pixel defining layer in contact with the second planarization layer.

Each of the plurality of anode electrodes may include a stacked structure of a reflective metal material and a transparent conductive material covering the reflective metal material. A thickness of the second gas blocking surface may be smaller than a thickness of the first gas blocking surface.

The first planarization layer may include a third gas blocking surface disposed on a surface in contact with the second planarization layer. The third gas blocking surface may include less oxygen than a surface of the first planarization layer adjacent to the substrate.

A transistor of the two or more transistors comprised in each of the plurality of pixel driving units may include a semiconductor layer disposed on the substrate and a gate electrode disposed on a gate insulating layer covering the semiconductor layer. The first planarization layer may be disposed on an interlayer insulating layer covering the gate electrode.

A transistor of the two or more transistors comprised in each of the plurality of pixel driving units may include a first semiconductor layer disposed on the substrate and including a silicon semiconductor, and a first gate electrode disposed on a first gate insulating layer covering the first semiconductor layer and covered with a second gate insulating layer. Other transistor of the two or more transistors comprised in each of the plurality of pixel driving units may include a second semiconductor layer including an oxide semiconductor and disposed on a first interlayer insulating layer covering the second gate insulating layer, and a second gate electrode disposed on a third gate insulating layer covering the second semiconductor layer and covered with a second interlayer insulating layer. The first planarization layer may be disposed on the second interlayer insulating layer.

The circuit array layer may further include an auxiliary planarization layer disposed between the second interlayer insulating layer and the first planarization layer and including an organic insulating material. A plurality of pixels each including a first emission area, a second emission area, and a third emission area which are adjacent to each other among the plurality of emission areas and correspond to different colors may be provided. The auxiliary planarization layer may be in contact with the substrate in a groove corresponding to a boundary between the plurality of pixels.

The auxiliary planarization layer may include a gas blocking surface disposed on a surface in contact with the first planarization layer.

According to an embodiment, a method for manufacturing a display device, includes: providing a substrate comprising a display area including a light emission area, and a non-emission area which is adjacent to the light emission area; providing, on the substrate, a pixel driving circuit corresponding to the light emission area; providing a first planarization layer on the pixel driving circuit and comprising an organic insulating material; providing, on the first planarization layer, an anode connection electrode connected to the pixel driving circuit; providing, on the first planarization layer, a second planarization layer on the anode connection electrode and comprising an organic insulating material; providing, on the second planarization layer, an anode electrode corresponding to the light emission area and connected to the anode connection electrode; providing, on the second planarization layer, a pixel defining layer corresponding to the non-emission area, overlapping an edge of the anode electrode, and comprising an organic insulating material; providing a light emitting layer corresponding to the light emission area, on the anode electrode; providing a cathode electrode corresponding to the light emission area, on the pixel defining layer and the light emitting layer; and providing for a layer among the first planarization layer, the second planarization layer and the pixel defining layer, a gas blocking thickness portion which extends from a surface of the layer which is closest to the cathode electrode, wherein the providing of the gas blocking thickness portion includes providing nitrogen plasma treatment to the layer.

The method may further include, before the providing of the light emitting layer, providing a first common layer comprising a hole transport layer including an organic material having a hole transport property, on the anode electrode, and may further include, before the providing of the cathode electrode, providing a second common layer including an electron transport layer comprising an organic material having an electron transport property, on the pixel defining layer and the light emitting layer.

The providing of the pixel defining layer may include providing an organic insulating material layer on the anode electrode and on the second planarization layer, and removing a part of the organic insulating material layer corresponding to the light emission area, after the providing of the pixel defining layer, the nitrogen plasma treatment may be performed to provide a first gas blocking thickness portion extended from a surface of the pixel defining layer which is closest to the cathode electrode, and in the providing of the second common layer, the second common layer may be in contact with the first gas blocking thickness portion of the pixel defining layer.

The organic insulating material layer may include a carbon-carbon bond and a carbon-oxygen bond, and in the performing of the nitrogen plasma treatment after the providing of the pixel defining layer, the surface of the pixel defining layer may be exposed to the nitrogen plasma treatment, and a part of each of the carbon-carbon bond and the carbon-oxygen bond at the surface of the pixel defining layer may be replaced by a carbon-nitrogen-oxygen bond, to provide the first gas blocking thickness portion at the surface of the pixel defining layer.

The first gas blocking thickness portion of the pixel defining layer may include less oxygen than a surface of the pixel defining layer which is in contact with the second planarization layer.

The providing of the pixel defining layer by removing the part of the organic insulating material layer which corresponds to the light emission area may include: removing a portion of the part of the organic insulating material layer which corresponds to the light emission area, by using an etching material; and removing a residue of the organic insulating material layer remaining on the anode electrode, by using oxygen plasma.

The anode electrode may include a reflective metal material and a transparent conductive material.

In the providing of the second planarization layer, the second planarization layer may include an organic insulating material including a carbon-carbon bond and a carbon-oxygen bond, the method may further include, after the providing of the first planarization layer, providing a first anode contact hole corresponding to the pixel driving circuit and penetrating the first planarization layer, the method may further include, after the providing of the second planarization layer, providing a second anode contact hole corresponding to the anode connection electrode and penetrating the second planarization layer; and providing a first gas blocking thickness portion at a surface of the second planarization layer which is closest to the cathode electrode, by performing the nitrogen plasma treatment at the surface of the second planarization layer.

In the performing of the nitrogen plasma treatment at the surface of the second planarization layer, a part of each of the carbon-carbon bond and the carbon-oxygen bond on the surface of the second planarization layer may be replaced by a carbon-nitrogen-oxygen bond by the nitrogen plasma treatment, to provide the first gas blocking thickness portion at the surface of the second planarization layer.

The first gas blocking thickness portion of the second planarization layer may include less oxygen than a surface of the second planarization layer which is in contact with the first planarization layer.

After the providing of the pixel defining layer, the first gas blocking thickness portion of the second planarization layer may be in contact with the anode electrode and the pixel defining layer.

The providing of the pixel defining layer may include: providing an organic insulating material layer on the anode electrode and on the second planarization layer; removing a part of the organic insulating material layer on the second planarization layer which corresponds to the light emission area; and providing a second gas blocking thickness portion at a surface of the pixel defining layer which is closest to the cathode electrode, by performing the nitrogen plasma treatment at the surface of the pixel defining layer, wherein in the providing of the second common layer, the second common layer may be in contact with the second gas blocking thickness portion of the pixel defining layer.

The second gas blocking thickness portion of the pixel defining layer may include less oxygen than a surface of the pixel defining layer which is in contact with the second planarization layer.

The first planarization layer, the second planarization layer and the pixel defining layer may be in order from the substrate, and a thickness of the second gas blocking thickness portion of the pixel defining layer may be smaller than a thickness of the first gas blocking thickness portion of the second planarization layer.

The method may further include, after the providing of the first planarization layer, providing the first anode contact hole; and providing a third gas blocking thickness portion at a surface of the first planarization layer which is closest to the cathode electrode, by performing the nitrogen plasma treatment at the surface of the first planarization layer.

According to another embodiment, a method for manufacturing a display device, includes preparing a substrate including a display area in which a plurality of emission areas is arranged, disposing, on the substrate, two or more transistors comprised in each of a plurality of pixel driving units respectively corresponding to the plurality of emission areas, disposing a first planarization layer covering the two or more transistors comprised in each of the pixel driving units and including an organic insulating material, disposing, on the first planarization layer, a plurality of anode connection electrodes respectively connected to the plurality of pixel driving units, disposing, on the first planarization layer, a second planarization layer covering the plurality of anode connection electrodes and including an organic insulating material, disposing, on the second planarization layer, a plurality of anode electrodes respectively corresponding to the plurality of emission areas and respectively connected to the plurality of anode connection electrodes, disposing, on the second planarization layer, a pixel defining layer corresponding to a non-emission area between the plurality of emission areas, covering an edge of each of the plurality of anode electrodes, and including an organic insulating material, disposing a plurality of light emitting layers respectively corresponding to the plurality of emission areas on the plurality of anode electrodes, respectively, and disposing a cathode electrode corresponding to the plurality of emission areas on the pixel defining layer and the plurality of light emitting layers. The method further includes providing a gas blocking surface by performing nitrogen (N₂) plasma treatment after at least one of the disposing of the first planarization layer, the disposing of the second planarization layer, and the disposing of the pixel defining layer.

The method may further include, before the disposing of the plurality of light emitting layers, disposing a first common layer including a hole transport layer including an organic material having a hole transport property on the plurality of anode electrodes. The method may further include, before the disposing of the cathode electrode, disposing a second common layer including an electron transport layer including an organic material having an electron transport property on the pixel defining layer and the plurality of light emitting layers.

The disposing of the pixel defining layer may include a process of disposing an organic insulating material layer covering the plurality of anode electrodes on the second planarization layer, and a process of providing the pixel defining layer by removing a part of the organic insulating material layer on the second planarization layer corresponding to the plurality of emission areas. After the disposing of the pixel defining layer, the nitrogen (N₂) plasma treatment may be performed to dispose the gas blocking surface on a surface of the pixel defining layer. In the disposing of the second common layer, the second common layer may be in contact with the gas blocking surface of the pixel defining layer.

The organic insulating material layer may include a carbon-carbon bond and a carbon-oxygen bond. In the performing of the nitrogen (N₂) plasma treatment after the disposing of the pixel defining layer, the surface of the pixel defining layer may be exposed to the nitrogen (N₂) plasma treatment, a part of each of the carbon-carbon bond and the carbon-oxygen bond is replaced by a carbon-nitrogen-oxygen bond, so that the gas blocking surface is provided on the surface of the pixel defining layer.

The gas blocking surface of the pixel defining layer may include less oxygen than a surface of the pixel defining layer in contact with the second planarization layer.

The process of providing the pixel defining layer by removing a part of the organic insulating material layer on the second planarization layer corresponding to the plurality of emission areas may include a process of removing at least a part of the organic insulating material layer corresponding to the plurality of emission areas using a predetermined etching material, and a process of removing a residue of the organic insulating material layer remaining on each of the plurality of anode electrodes using oxygen (O₂) plasma.

In the disposing of the plurality of anode electrodes, each of the plurality of anode electrodes may have a stacked structure of a reflective metal material and a transparent conductive material.

In the disposing of the second planarization layer, the second planarization layer may include an organic insulating material including a carbon-carbon bond and a carbon-oxygen bond. The method may further include, after the disposing of the first planarization layer, disposing a plurality of first anode contact holes corresponding to a part of each of the plurality of pixel driving units and penetrating the first planarization layer. The method may further include, after the disposing of the second planarization layer, disposing a plurality of second anode contact holes corresponding to a part of each of the plurality of anode connection electrodes and penetrating the second planarization layer, and disposing a first gas blocking surface on a surface of the second planarization layer by performing nitrogen (N₂) plasma treatment on the second planarization layer.

In the performing of the nitrogen (N₂) plasma treatment on the surface of the second planarization layer, a part of each of the carbon-carbon bond and the carbon-oxygen bond on the surface of the second planarization layer may be replaced by a carbon-nitrogen-oxygen bond by the nitrogen (N₂) plasma treatment to provide the first gas blocking surface.

The first gas blocking surface of the second planarization layer may include less oxygen than a surface of the second planarization layer in contact with the first planarization layer.

After the disposing of the pixel defining layer, the first gas blocking surface of the second planarization layer may be in contact with the plurality of second anode contact holes, the plurality of anode electrodes, and the pixel defining layer.

The disposing of the pixel defining layer may include disposing an organic insulating material layer covering the plurality of anode electrodes on the second planarization layer, providing the pixel defining layer by removing a part of the organic insulating material layer on the second planarization layer corresponding to the plurality of emission areas, and disposing a second gas blocking surface on a surface of the pixel defining layer by performing nitrogen (N₂) plasma treatment on the pixel defining layer. In the disposing of the second common layer, the second common layer may be in contact with the second gas blocking surface of the pixel defining layer.

The second gas blocking surface of the pixel defining layer may include less oxygen than a surface of the pixel defining layer in contact with the second planarization layer.

A thickness of the second gas blocking surface may be smaller than a thickness of the first gas blocking surface.

The method may further include, after the disposing of the first planarization layer, disposing the plurality of first anode contact holes, and disposing a third gas blocking surface on a surface of the first planarization layer by performing nitrogen (N₂) plasma treatment on the surface of the first planarization layer.

At least some of the above and other features of the invention are set out in the claims.

A display device according to embodiments includes a gas blocking surface disposed on at least one of a first planarization layer, a second planarization layer and a pixel defining layer made of an organic insulating material.

The gas blocking surface is disposed on the surface facing a cathode electrode, and is formed as an area having a relatively low oxygen content.

Due to the gas blocking layer, the influence of oxygen, moisture, and gas from the organic insulating material forming the first planarization layer, the second planarization layer, and the pixel defining layer on the oxidation of a second common layer and the oxidation of the cathode electrode may be reduced.

Accordingly, the luminance and lifespan of the display device may be increased.

The effects of the present disclosure are not limited to the aforementioned effects, and various other effects are included in the present specification.

### BRIEF DESCRIPTION OF THE DRAWINGS

The above and other aspects and features of the present disclosure will become more apparent by describing in detail embodiments thereof with reference to the attached drawings, in which:
FIG. 1 is a perspective view illustrating a display device according to an embodiment;
FIGS. 2 and 3 are plan views illustrating a display device according to an embodiment;
FIG. 4 is a cross-sectional view showing an example of the plane taken along line A-A' of FIG. 3;
FIG. 5 is a layout diagram showing an example of the circuit array layer of FIG. 4;
FIG. 6 is an equivalent circuit diagram showing an embodiment of a pixel driving unit illustrated in FIG. 5;
FIG. 7 is a layout diagram showing in detail an example of the sensor electrode layer of FIG. 4;
FIG. 8 is an enlarged plan view of the touch sensing area of FIG. 7;
FIG. 9 is an enlarged plan view of area B of FIG. 8;
FIG. 10 is a cross-sectional view showing an example of the plane taken along line C-C' of FIG. 9 according to an embodiment;
FIG. 11 is a cross-sectional view showing area D of FIG. 10;
FIGS. 12 to 17 are cross-sectional views showing an example of the plane taken along line C-C' of FIG. 9 according to embodiments, respectively;
FIGS. 18 and 19 are flowcharts illustrating the method for manufacturing display devices according to embodiments; and
FIGS. 20 to 37 are cross-sectional views of structures of the method in FIGS. 18 and 19.

### DETAILED DESCRIPTION

The embodiments will now be described more fully hereinafter with reference to the accompanying drawings. The embodiments may, however, be provided in different forms and should not be construed as limiting. The same reference numbers indicate the same components throughout the disclosure. In the accompanying figures, the thickness of layers and regions may be exaggerated for clarity.

Some of the parts which are not associated with the description may not be provided in order to describe embodiments of the disclosure.

It will also be understood that when a layer is referred to as being related to another element such as being "on" another layer or substrate, it can be directly on the other layer or substrate, or intervening layers may also be present. In contrast, when an element is referred to as being related to another element such as being "directly on" another element, there may be no intervening elements present. As being in contact with each other or in a "direct" relationship, elements may form an interface therebetween.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art. The expression "not overlap" may include meaning such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

The spatially relative terms "below," "beneath," "lower," "above," "upper," or the like, may be used herein for ease of description to describe the relations between one element or component and another element or component as illustrated in the drawings. It will be understood that the spatially relative terms are intended to encompass different orientations of the device in use or operation, in addition to the orientation depicted in the drawings. For example, in the case where a device illustrated in the drawing is turned over, the device positioned "below" or "beneath" another device may be placed "above" another device. Accordingly, the illustrative term "below" may include both the lower and upper positions. The device may also be oriented in other directions and thus the spatially relative terms may be interpreted differently depending on the orientations.

When an element is referred to as being "connected" or "coupled" to another element, the element may be "directly connected" or "directly coupled" to another element, or "electrically connected" or "electrically coupled" to another element with one or more intervening elements interposed therebetween.

It will be further understood that when the terms "comprises," "comprising," "has," "have," "having," "includes" and/or "including" are used, they may specify the presence of stated features, integers, steps, operations, elements and/or components, but do not preclude the presence or addition of other features, integers, steps, operations, elements, components, and/or any combination thereof.

It will be understood that, although the terms "first," "second," "third," or the like may be used herein to describe various elements, these elements should not be limited by these terms. These terms are used to distinguish one element from another element or for the convenience of description and explanation thereof. For example, when "a first element" is discussed in the description, it may be termed "a second element" or "a third element," and "a second element" and "a third element" may be termed in a similar manner without departing from the teachings herein.

The terms "about" or "approximately" as used herein are inclusive of the stated value and mean within an acceptable range of deviation for the particular value as determined by one of ordinary skill in the art, considering the measurement in question and the error associated with measurement of the particular quantity (for example, the limitations of the measurement system). For example, "about" may mean within one or more standard deviations, or within ± 30%, 20%, 10% or 5% of the stated value.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or." In the specification and the claims, the phrase "at least one of' is intended to include the meaning of "at least one selected from the group of' for the purpose of its meaning and interpretation. For example, "at least one of A and B" may be understood to mean "A, B, or A and B." For example, a reference number labeling a singular form of an element within the drawing figures may be used to reference a plurality of the singular element within the text of specification.

Unless otherwise defined or implied, all terms used herein (including technical and scientific terms) have the same meaning as commonly understood by those skilled in the art to which this disclosure pertains. It will be further understood that terms, such as those defined in commonly used dictionaries, should be interpreted as having a meaning that is consistent with their meaning in the context of the relevant art and will not be interpreted in an ideal or excessively formal sense unless clearly defined in the specification.

Hereinafter, embodiments will be described with reference to the accompanying drawings.

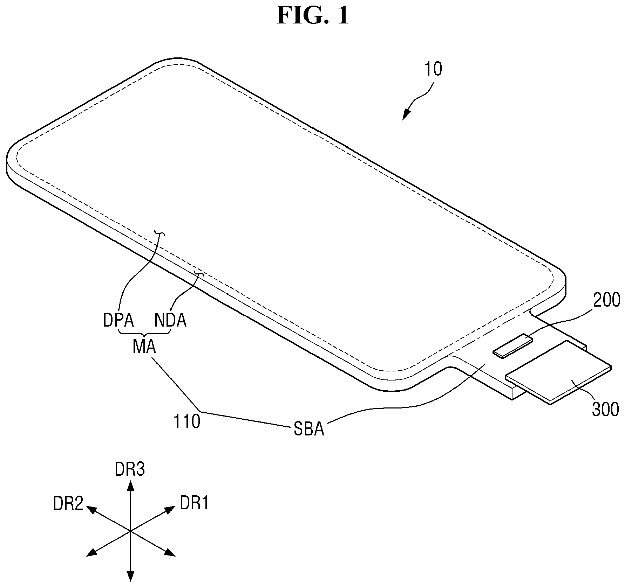

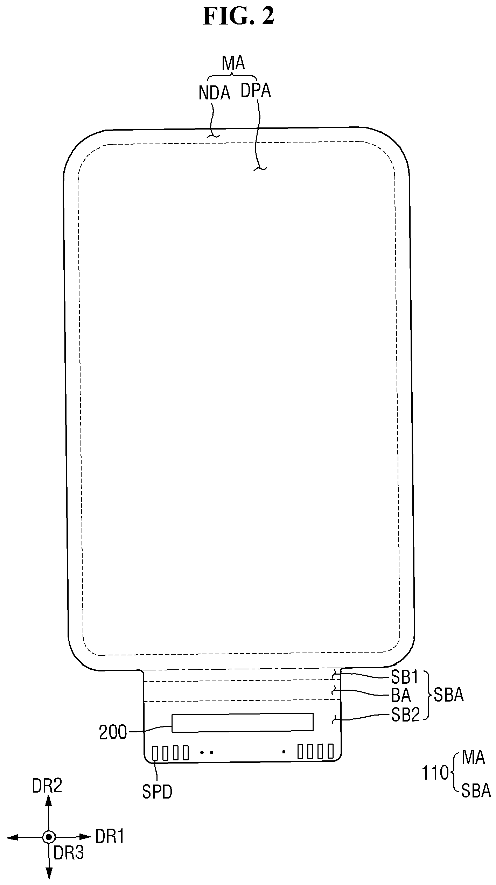

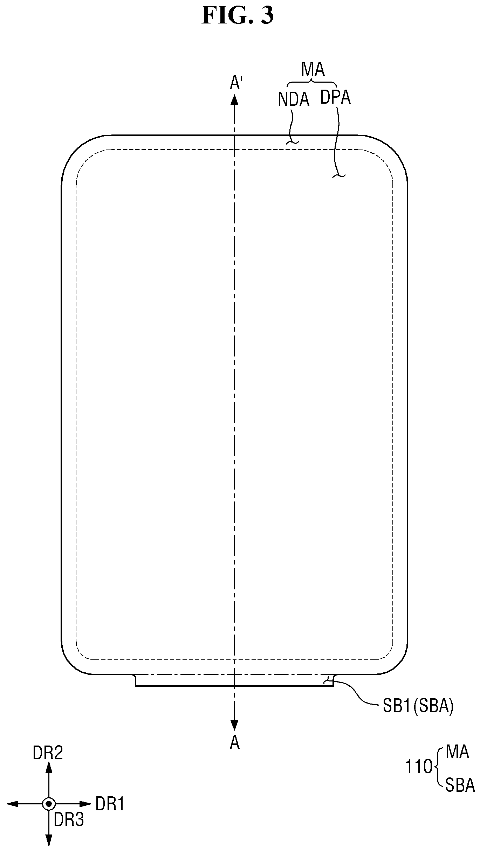

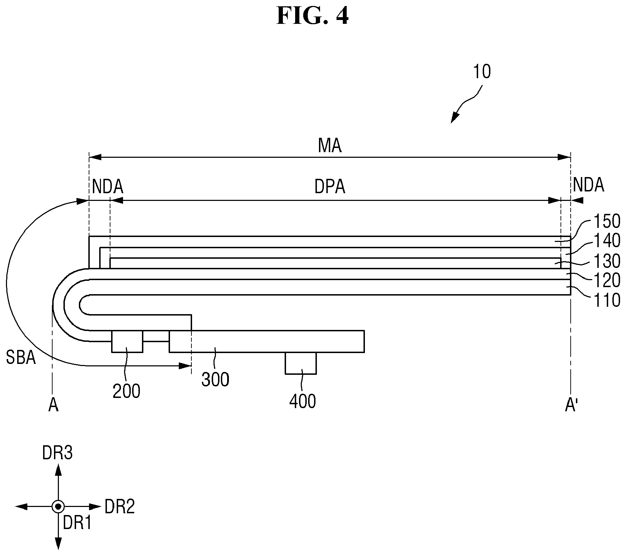

FIG. 1 is a perspective view illustrating a display device according to an embodiment. FIGS. 2 and 3 are plan views illustrating a display device according to an embodiment. FIG. 4 is a cross-sectional view showing an example of the plane taken along line A-A' of FIG. 3.

Referring to FIG. 1, a display device 10 is a device for displaying a moving image or a still image. The display device 10 may be used as a display screen of various devices, such as a television, a laptop computer, a monitor, a billboard and an Internet-of-Things (IOT) device, as well as portable electronic devices such as a mobile phone, a smartphone, a tablet personal computer (PC), a smart watch, a watch phone, a mobile communication terminal, an electronic notebook, an electronic book, a portable multimedia player (PMP), a navigation device and an ultra-mobile PC (UMPC).

The display device 10 may be a light emitting display device such as an organic light emitting display using an organic light emitting diode, a quantum dot light emitting display including a quantum dot light emitting layer, an inorganic light emitting display including an inorganic semiconductor, and a micro light emitting display using a micro or nano light emitting diode (LED). Hereinafter, a case in which the display device 10 is an organic light emitting display device will be mainly described, but the present disclosure may be applied to a display device including an organic insulating material, an organic light emitting material, and a metal material.

The display device 10 may be formed to be flat, but is not limited thereto. For example, the display device 10 may include a curved portion formed (or provided) at left and right ends and having a predetermined curvature or a varying curvature. In addition, the display device 10 may be formed flexibly (e.g., flexible) so that it can be curved, bent, folded, or rolled (e.g., curvable, bendable, foldable or rollable).

The display device 10 may include a substrate 110, a display driving circuit 200, and a circuit board 300.

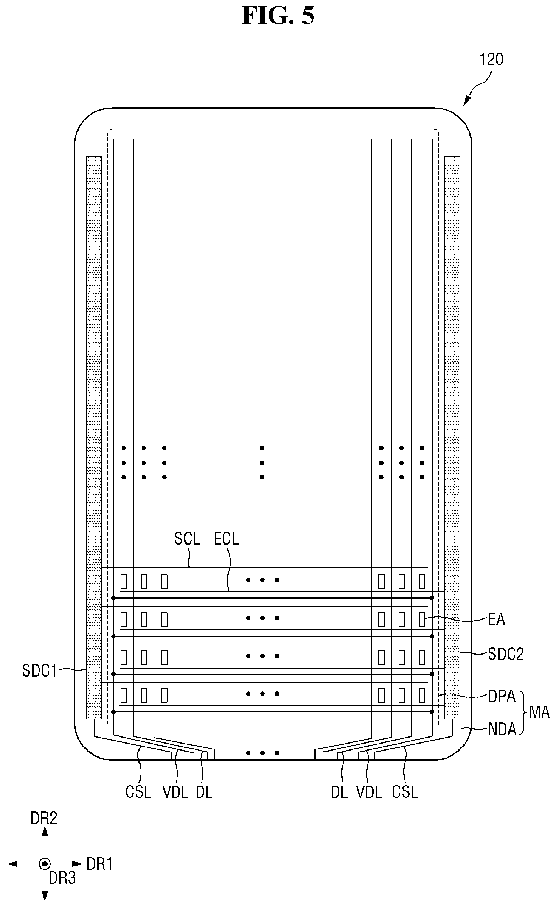

The substrate 110 includes a display area DPA in which a plurality of emission areas EA (see FIG. 5) for displaying an image are arranged. The emission area EA may also be referred to as a light emission area or a light emitting area.

That is, the substrate 110 may include a main region MA including both the display area DPA and a non-display area NDA which is adj acent to the display area DPA as a peripheral area of the display area DPA, and a sub-region SBA protruding in a second direction DR2 from one side of the main region MA. Various components or layers of the display device may have a main region MA, a display area DPA, a non-display area NDA, a peripheral area, a sub-region SBA, etc. corresponding to those described above for the substrate 110.

FIGS. 1 and 2 illustrate a state in which the sub-region SBA is unfolded to be disposed side by side with the main region MA. That is, the display device which is unfolded may dispose the sub-region SBA to be flat, or to be coplanar with the main region MA. On the other hand, FIGS. 3 and 4 illustrate that the sub-region SBA is bent. That is, the display device may be bendable at the sub-region SBA.

The display area DPA may, in plan view, be formed in a rectangular shape having short sides in a first direction DR1 and long sides in a second direction DR2 crossing the first direction DR1. A plane may be defined by the first direction DR1 and the second direction DR2 crossing each other, and a plan view may be along a direction crossing the plane. The direction crossing the plane may be referred to as a third direction DR3 or a thickness direction. The corner where the short side in the first direction DR1 and the long side in the second direction DR2 meet may be rounded to have a predetermined curvature or may be right-angled, in the plan view. The planar shape of the display area DPA is not limited to the rectangular shape, and may be formed in another polygonal shape, a circular shape or an elliptical shape.

The display area DPA may occupy most of the main region MA. The display area DPA may be disposed at the center of the main region MA. In an embodiment, the display area DPA may be spaced apart from outer edges of the display device.

The non-display area NDA may be adjacent to the display area DPA and may be disposed outside the edge (e.g., the outer edge or outer boundary) of the display area DPA. That is, the non-display area NDA may be an area outside the display area DPA. The non-display area NDA may be disposed to surround the display area DPA. The non-display area NDA may be an edge area of the main region MA of the substrate 110.

The main region MA may have a plurality of sides in the plan view, and the sub-region SBA may protrude from one side of the main region MA, in (or along) the second direction DR2. The length of the sub-region SBA in the second direction DR2 may be less than the length of the main region MA in the second direction DR2. The length of the sub-region SBA in the first direction DR1 may be substantially equal to or less than the length of the main region MA in the first direction DR1.

The sub-region SBA may include a bending area BA that is deformable to be bent, and a first sub-region SB1 and a second sub-region SB2 that are in contact with both of opposing sides of the bending area BA. As being in contact, elements may form an interface therebetween or a boundary therebetween, without being limited thereto.

The first sub-region SB1 is disposed between the main region MA and the bending area BA. One side of the first sub-region SB1 may be in contact with the non-display area NDA of the main region MA, and the other side of the first sub-region SB1 may be in contact with the bending area BA.

The second sub-region SB2 is spaced apart from the main region MA with the bending area BA interposed therebetween. The display device which is bent at the bending area BA may dispose the second sub-region SB2 on the bottom surface of the substrate 110 (see FIG. 4). That is, the second sub-region SB2 may overlap the main region MA in a third direction DR3 of a substrate 110, by bending of the display device at the bending area BA.

One side of the second sub-region SB2 may be in contact with the bending area BA. The other side of the second sub-region SB2 may be in contact with a part of the edge of the substrate 110. That is, the other side of the second sub-region SB2 may be aligned with or coincide with the outer edge of the substrate 110 at the end portion of the display device.

Signal pads SPD and the display driving circuit 200 may be disposed in the second sub-region SB2.

The display driving circuit 200 may generate signals and voltages (e.g., electrical signals) for driving the pixel driving units PD (e.g., a pixel driving circuit provided in plural including a plurality of pixel driving circuits) of the display area DPA. The display driving circuit 200 may be connected to the display area DPA for driving the pixel driving units PD of the display area DPA.

The display driving circuit 200 may be provided as an integrated circuit (IC) and mounted on the second sub-region SB2 of the substrate 110 by a chip on glass (COG) method, a chip on plastic (COP) method, or an ultrasonic bonding method, but the present disclosure is not limited thereto. For example, the display driving circuit 200 may be attached onto the circuit board 300 by a chip on film (COF) method.

The circuit board 300 may be attached to and electrically connected to the signal pads SPD of the second sub-region SB2 using a low-resistance high-reliability material such as SAP or an anisotropic conductive film. That is, the circuit board 300 may be attached to and electrically connected to the substrate 110 at the signal pads SPD of the second sub-region SB2.

The pixel driving units PD of the display area DPA, and the display driving circuit 200, may receive digital video data, timing signals, and driving voltages as various electrical signals, from the circuit board 300.

The circuit board 300 may be a flexible printed circuit board, a printed circuit board, or a flexible film such as a chip on film.

Referring to FIG. 4, the display device 10 includes the substrate 110 including the display area DPA in which the plurality of emission areas EA (see FIG. 5) are arranged, a circuit array layer 120 disposed on the substrate 110, and a light emitting array layer 130 disposed on the circuit array layer 120.

In addition, the display device 10 may further include a sealing structure 140 covering the light emitting array layer 130, and a sensor electrode layer 150 disposed on the sealing structure 140. The layers 110 through 140 may constitute a display panel of the display device 10, without being limited thereto.

The substrate 110 may be formed of (or include) an insulating material such as a polymer resin. For example, the substrate 110 may be formed of polyimide. The substrate 110 may be a flexible substrate which can be bent, folded or rolled.

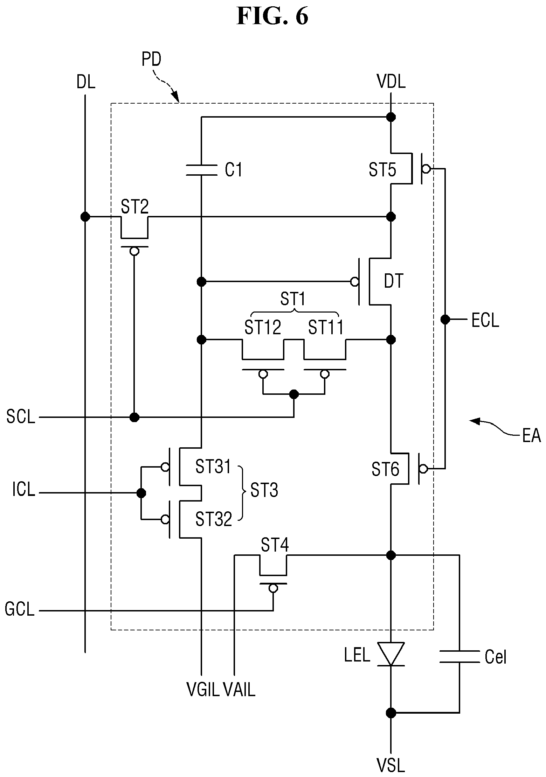

The circuit array layer 120 may be disposed in the main region MA and in the sub-region SBA of the substrate 110. The circuit array layer 120 includes the plurality of pixel driving units PD (see FIG. 6) respectively corresponding to the plurality of emission areas EA (see FIG. 5).

The light emitting array layer 130 is disposed on the circuit array layer 120 and corresponds to the display area DPA of the main region MA. The light emitting array layer 130 includes a plurality of light emitting elements LEL (see FIG. 6) respectively corresponding to the plurality of emission areas EA.

The sealing structure 140 is disposed on the circuit array layer 120, corresponds to the main region MA, and covers the light emitting array layer 130. The sealing structure 140 may include a structure in which at least one inorganic layer and at least one organic layer are stacked on the light emitting array layer 130. In an embodiment including more than two layers, the sealing structure 140 may include more than one of the inorganic layer and/or the organic layer, and the inorganic and organic layers may be alternately stacked on the light emitting array layer 130.

The sensor electrode layer 150 may be disposed on the sealing structure 140 and may correspond to the main region MA. The sensor electrode layer 150 may include touch electrodes for sensing a touch of a person or an object (e.g., an input-sensing layer which senses an external input to the display device).

The display device 10 may further include a cover window (not shown) disposed on the sensor electrode layer 150. In an embodiment, the cover window may face the substrate 110 with the layers 120 to 150 therebetween. The cover window may be attached to the sensor electrode layer 150 by a transparent adhesive member such as an optically clear adhesive (OCA) film or an optically clear resin (OCR). The cover window may be made of an inorganic material such as glass, or an organic material such as plastic or a polymer material. Due to the cover window, the sensor electrode layer 150, the sealing structure 140, the light emitting array layer 130, and the circuit array layer 120 may be protected from electrical and physical impact on the display surface. The display surface of the display device may be defined as an outer surface of the display device. A layer which is furthest from the substrate 110 may define the display surface. In an embodiment, the cover window may define the display surface

In addition, the display device 10 may further include an anti-reflection member (not shown) disposed between the sensor electrode layer 150 and the cover window. The anti-reflection member may be a polarizing film or a color filter. The anti-reflection member blocks external light reflected from the sensor electrode layer 150, the sealing structure 140, the light emitting array layer 130, the circuit array layer 120, and the interfaces therebetween, so that it is possible to prevent a decrease in visibility of an image displayed by the display device 10.

The display device 10 may further include a touch driving circuit 400 for driving the sensor electrode layer 150.

The touch driving circuit 400 may be provided as an integrated circuit (IC). The touch driving circuit 400 may be electrically connected to the sensor electrode layer 150, while being mounted on the circuit board 300 bonded to the signal pads SPD.

Alternatively, similarly to the display driving circuit 200, the touch driving circuit 400 may be mounted on the second sub-region SB2 of the substrate 110.

The touch driving circuit 400 may apply a touch driving signal to a plurality of driving electrodes provided on the sensor electrode layer 150, receive a touch sensing signal of each of a plurality of touch nodes through the plurality of sensing electrodes, and sense a charge change amount of mutual capacitance based on the touch sensing signal.

That is, the touch driving circuit 400 may determine whether an external input (such as a user's touch occurs), whether the external input (e.g., the user) is proximate, and the like, according to the touch sensing signals of each of the plurality of touch nodes. A touch or contact of the external input indicates direct contact of an object (e.g., an input tool such as a user's finger or a pen) with a surface (such as the front surface and/or display surface) of the display device 10. The proximity of the external input indicates that an object (e.g., the input tool such as a user's finger or a pen) is positioned spaced apart from the front surface of the display device 10, but in close or proximate distance such as by hovering.

FIG. 5 is a layout diagram (e.g., a plan view) showing an example of the circuit array layer of FIG. 4.

Referring to FIG. 5, the substrate 110 may include a plurality of emission areas EA arranged in (or along) the first direction DR1 and in (or along) the second direction DR2, within the display area DPA of the main region MA.

The circuit array layer 120 may include the plurality of pixel driving units PD (see FIG. 6) respectively corresponding to the plurality of emission areas EA.

In addition, the circuit array layer 120 may include a scan line SCL, an emission control line ECL, a data line DL, and a first power line VDL connected to each of the plurality of pixel driving units PD (see FIG. 6).

The scan line SCL may extend in the first direction DR1. As extending in the first direction DR1, the major dimension of the scan line SCL is extended in the direction.

The scan line SCL may supply a scan signal as an electrical signal corresponding to whether or not data is written to the plurality of pixel driving units PD.

At least one end of the scan line SCL may be connected to a first scan driver SDC1 or a second scan driver SDC2.

The first scan driver SDC1 and the second scan driver SDC2 may be disposed in some areas of the non-display area NDA that are in contact with both sides of the display area DPA in the first direction DR1. Although FIG. 5 illustrates a case in which the display device 10 includes the first scan driver SDC1 and the second scan driver SDC2 adjacent to both of opposing sides of the display area DPA, this is only an example, and the arrangement of the scan drivers of the display device 10 according to an embodiment may be variously changed. For example, the display device 10 may include one scan driver adjacent to any one side of the display area DPA. For another example, the display device 10 may include scan drivers that are divided and arranged in the display area DPA.

The first scan driver SDC1 and the second scan driver SDC2 may output respective scan signals to the scan lines SCL of the display area DPA in response to scan control signals of the control signal lines SCL.

For example, the first scan driver SDC1 and the second scan driver SDC2 may receive the scan control signals including a scan timing control signal corresponding to the output timing of the scan signal, and two or more scan clock signals corresponding to the generation of the scan signal through the control signal lines SCL.

In addition, the first scan driver SDC1 and the second scan driver SDC2 may sequentially output the scan signal to the scan lines SCL of the display area DPA during one frame period for image display in response to the control signals.

The emission control line ECL may extend in the first direction DR1.

The emission control line ECL may be disposed on the same layer as the scan line SCL and may be spaced apart from the scan line SCL. The emission control line ECL may supply the emission gate signal corresponding to whether or not light emission is started to the plurality of pixel driving units PD. As being on a same layer, elements may be provided in a same process and/or as including a same material as each other, elements may be in a same layer as each other as respective portions or patterns of a same material layer, may be on a same layer by forming an interface with a same underlying or overlying layer, etc., without being limited thereto.

Although not shown in detail in FIG. 5, the circuit array layer 120 of the display device 10 may further include an emission gate driver (not shown) for outputting the emission gate signal to the emission control line ECL.

The emission gate driver may be provided separately from the first scan driver SDC1 and the second scan driver SDC2.

Alternatively, the emission gate driver may be implemented as a part of at least one of the first scan driver SDC1 and the second scan driver SDC2. That is, at least one of the first scan driver SDC1 and the second scan driver SDC2 may include a circuit for outputting the emission gate signal.

The data line DL may extend in the second direction DR2 and may supply the data signal outputted from the display driving circuit 200 to each of the plurality of pixel driving units PD. That is, the display driving circuit 200 may be connected to the display area DPA (e.g., pixel driving units PD) by the data line DL, without being limited thereto.

The display driving circuit 200 may apply the data signal of each of the plurality of emission areas EA, to the data lines DL, based on digital video data and timing signals transmitted from the circuit board 300.

Further, the display driving circuit 200 may be connected to the first scan driver SDC 1 and the second scan driver SDC2 through the control signal lines SCL, and may supply the scan control signal to the first scan driver SDC1 and the second scan driver SDC2 based on the digital video data and the timing signals.

The first power line VDL is used for transmitting a first power for driving the light emitting element to the plurality of pixel driving units PD. The first power line VDL may transmit the first power supplied from the display driving circuit 200 or the circuit board 300, to the plurality of pixel driving units PD.

FIG. 6 is an equivalent circuit diagram showing an example of any one pixel driving unit illustrated in FIG. 5.

Referring to FIG. 6, each of the plurality of emission areas EA may include a light emitting element LEL and a pixel driving unit PD that supplies a driving (electrical) current to the light emitting element LEL.

The light emitting element LEL may have a structure including an anode electrode and a cathode electrode facing each other, and a light emitting layer disposed between the anode electrode and the cathode electrode.

For example, the light emitting element LEL may be an organic light emitting diode having a light emitting layer made of an organic light emitting material. Alternatively, the light emitting element LEL may be an inorganic light emitting element including a light emitting layer made of an inorganic semiconductor. Alternatively, the light emitting element LEL may be a quantum dot light emitting element having a quantum dot light emitting layer. Alternatively, the light emitting element LEL may be a micro light emitting diode.

The pixel driving unit PD may include a driving transistor DT generating a driving current, at least one switch element, and at least one capacitor.

For example, the pixel driving unit PD may include switch elements of a first transistor (switch transistor) ST1, a second transistor ST2, a third transistor ST3, a fourth transistor ST4, a fifth transistor ST5, and a sixth transistor ST6.

The driving transistor DT may include a gate electrode, a first electrode, and a second electrode, and may be connected in series with the light emitting element LEL, between the first power line VDL and a second power line VSL.

A capacitor Cel connected in parallel with the light emitting element LEL refers to a parasitic capacitance between the anode electrode and the cathode electrode.

A capacitor C1 may be connected between the first power line VDL and the gate electrode of the driving transistor DT.

A first transistor ST1 is disposed between the second electrode of the driving transistor DT and the gate electrode of the driving transistor DT. The first transistor ST1 may include first and second sub-transistors ST11 and ST12.

The second transistor ST2 is disposed between the data line DL and the first electrode of the driving transistor DT.

The gate electrode of each of the first transistor ST1 and the gate electrode of the second transistor ST2 is connected to the scan line SCL. Accordingly, when the scan signal is supplied through the scan line SCL, the first transistor ST1 and the second transistor ST2 are turned on.

At this time, the data signal of the data line DL is supplied to the first electrode of the driving transistor DT through the turned-on second transistor ST2.

In addition, the gate electrode and the second electrode of the driving transistor DT have the same potential through the turned-on first transistor ST1.

Accordingly, when the potential difference between the first electrode and the gate electrode of the driving transistor DT exceeds a threshold voltage, an electrical current between the first electrode and the second electrode of the driving transistor DT, e.g., a drain-source current (Ids), is generated.

When the drain-source current (Ids) of the driving transistor DT is supplied as the electrical driving current of the light emitting element LEL, the light emitting element LEL emits light having a luminance corresponding to the driving current of the driving transistor DT.

The third transistor ST3 is disposed between a gate initialization voltage line VGIL and the gate electrode of the driving transistor DT. The gate electrode of the third transistor ST3 is connected to an initialization control line ICL. The third transistor ST3 may include third and fourth sub-transistors ST31 and ST32.

When the third transistor ST3 is turned on based on an initialization control signal of the initialization control line ICL, the potential of the gate electrode of the driving transistor DT is initialized to a first initialization voltage by the gate initialization voltage line VGIL.

The fourth transistor ST4 is disposed between an emission initialization voltage line VAIL and the anode electrode of the light emitting element LEL. The gate electrode of the fourth transistor ST4 is connected to the gate control line GCL.

When the fourth transistor ST4 is turned on based on a gate control signal of the gate control line GCL, the potential of the anode electrode of the light emitting element LEL is initialized to a second initialization voltage by the emission initialization voltage line VAIL.

The fifth transistor ST5 is disposed between the first power line VDL and the first electrode of the driving transistor DT.

The sixth transistor ST6 is connected between the second electrode of the driving transistor DT and the anode electrode of the light emitting element LEL.

The gate electrode of each of the fifth transistor ST5 and the sixth transistor ST6 is connected to the emission control line ECL.

When the fifth transistor ST5 and the sixth transistor ST6 are turned on based on an emission control signal of the emission control line ECL, the driving current by the driving transistor DT is supplied to the light emitting element LEL, and the light emitting element LEL emits light based on the driving current.

As illustrated in FIG. 6, all of the driving transistor DT, the first transistor ST1, the second transistor ST2, the third transistor ST3, the fourth transistor ST4, the fifth transistor ST5, and the sixth transistor ST6 that are included in the pixel driving unit PD may be provided as P-type MOSFETs. In this case, each of the scan signal of the scan line SCL, the initialization control signal of the initialization control line ICL, the gate control signal of the gate control line GCL, and the emission control signal of the emission control line ECL may be a gate low-level signal for turning on the P-type MOSFET.

Alternatively, unlike the illustration of FIG. 6, some of the switching elements included in the pixel driving unit PD may be provided as the P-type MOSFET, and the other remaining portion may be provided as the N-type MOSFET. In this way, the switching elements provided with the P-type MOSFET and the switching elements provided with the N-type MOSFET may include semiconductor layers of different semiconductor materials. Accordingly, the floor area ratio (e.g., planar area) of the pixel area PX (otherwise referred to as a pixel PX) may be improved through the stacked structure, and it may be advantageous in improving resolution.

For example, although not separately illustrated, according to another example, the driving transistor DT, the second transistor ST2, the fourth transistor ST4, the fifth transistor ST5, and the sixth transistor ST6 among the switch elements of the pixel driving unit PD may be provided as the P-type MOSFET having a semiconductor layer of polysilicon semiconductor material, and the first transistor ST1 and the third transistor ST3 may be provided with the N-type MOSFET having a semiconductor layer of an oxide semiconductor material.

In this case, since the first transistor ST1 is not turned on with the same signal as the signal for the second transistor ST2, the gate electrode of the first transistor ST1 may be connected to the gate control line GCL instead of the scan line SCL. In this way, the fourth transistor ST4 may be turned on when the gate control line GCL supplies a gate low-level signal, and the first transistor ST1 may be turned on when the gate control line GCL supplies a gate high level signal. In addition, the third transistor ST3 may be turned on when the initialization control line ICL supplies a gate high level signal.

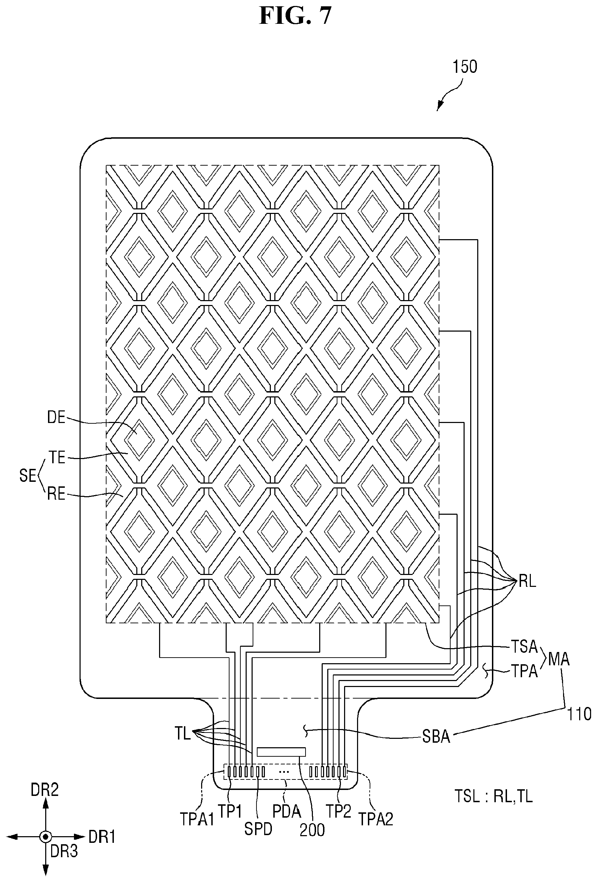

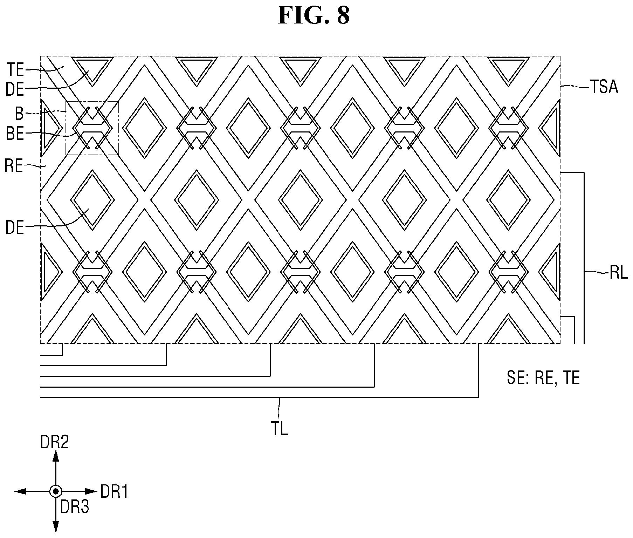

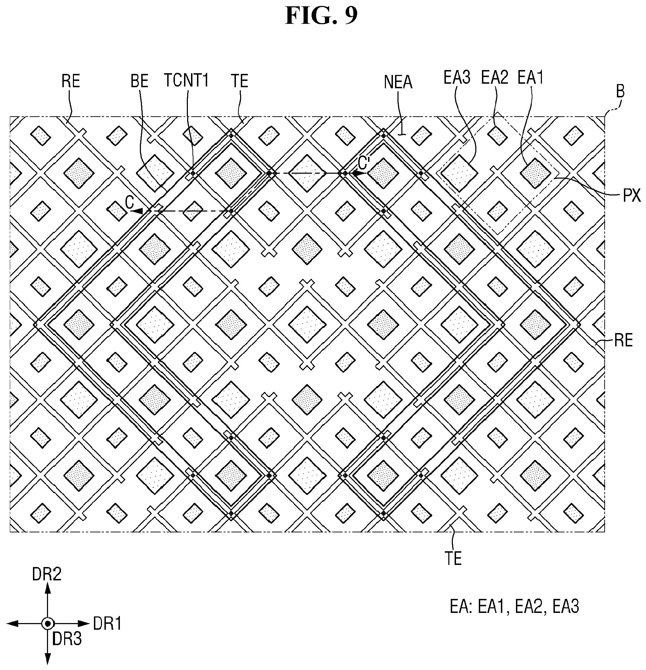

FIG. 7 is a layout diagram showing in detail an example of the sensor electrode layer of FIG. 4. FIG. 8 is an enlarged plan view of a part of the touch sensing area of FIG. 7. FIG. 9 is an enlarged plan view of area B of FIG. 8.

Although FIGS. 7 and 8 illustrate that the sensor electrode layer 150 includes two types of sensor electrodes SE, e.g., driving electrodes TE and sensing electrodes RE, and is driven in a mutual capacitance manner in which a voltage charged in a mutual capacitance is sensed through the sensing electrodes RE in a state where a driving signal is applied to the driving electrodes TE, the sensor electrode layer of an embodiment is not limited to the illustration of FIGS. 7 to 9.

FIGS. 7 and 8 illustrate only the sensor electrodes TE and RE, dummy patterns DE, sensor lines TSL, and sensor pads TP1 and TP2.

Referring to FIG. 7, the sensor electrode layer 150 includes a touch sensor area TSA for sensing a user's touch, and a touch peripheral area TPA disposed around the touch sensor area TSA. For example, the touch sensor area TSA may overlap the display area DPA, and the touch peripheral area TPA may overlap the non-display area NDA.

The sensor electrode layer 150 may include the sensor electrodes SE and the dummy patterns DE disposed in the touch sensor area TSA.

The sensor electrodes SE may be electrodes that generate a mutual capacitance to sense a touch of an object or a person.

The sensor electrodes SE may include the driving electrodes TE and the sensing electrodes RE. The sensing electrode RE may be defined as a first sensor electrode, and the driving electrode TE may be defined as a second sensor electrode. Alternatively, the driving electrode TE may be defined as a first sensor electrode, and the sensing electrode RE may be defined as a second sensor electrode.

The sensing electrodes RE may be arranged side by side in the first direction DR1 and in the second direction DR2. The sensing electrodes RE may be electrically connected to each other in the first direction DR1. The sensing electrodes RE adjacent in the first direction DR1 may be connected to each other. The sensing electrodes RE adjacent in the second direction DR2 may be electrically separated from each other.

The driving electrodes TE may be arranged side by side in the first direction DR1 and the second direction DR2. The driving electrode TE adjacent in the first direction DR1 may be electrically separated from each other. The driving electrodes TE may be electrically connected to each other in the second direction DR2. The driving electrodes TE adjacent in the second direction DR2 may be connected to each other through a bridge line BE of FIG. 8.

Referring to FIG. 8, the bridge line BE may be bent at least once. FIG. 8 illustrates that the bridge line BE has an angle bracket shape ("<" or ">"), but the planar shape of the bridge line BE is not limited thereto. Since the driving electrodes TE adjacent in the second direction DR2 are connected to each other via the plurality of bridge lines BE, even though one of the bridge lines BE is broken, the driving electrodes TE adjacent in the second direction DR2 may be stably connected. Although FIG. 8 illustrates that the adjacent driving electrodes TE are connected by two bridge lines BE, the number of the bridge lines BE between the adjacent driving electrodes TE is not limited thereto.

Since the driving electrodes TE and the sensing electrodes RE are spaced apart from each other, they are electrically separated at the intersections thereof. Accordingly, the mutual capacitance may be generated between the driving electrodes TE and the sensing electrodes RE.

Each of the dummy patterns DE may be surrounded by the driving electrode TE or the sensing electrode RE. Each of the dummy patterns DE may be electrically separated from the driving electrode TE or the sensing electrode RE. Each of the dummy patterns DE may be spaced apart from the driving electrode TE or the sensing electrode RE. Each of the dummy patterns DE may be electrically floating.

The length of the driving electrode TE in the first direction DR1 and the length of the driving electrode TE in the second direction DR2 may be approximately 3 millimeters (mm) to approximately 5 mm. The length of the driving electrode TE in the first direction DR1 indicates the distance from the left end to the right end of the driving electrode TE, such as being a maximum dimension along the first direction DR1, without being limited thereto. The length of the driving electrode TE in the second direction DR2 indicates the distance from the upper end to the lower end of the driving electrode TE, such as being a maximum dimension along the second direction DR2. The length of the sensing electrode RE in the first direction DR1 and the length of the sensing electrode RE in the second direction DR2 may also be approximately 3 mm to approximately 5 mm.

Although FIGS. 7 and 8 illustrate that each of the driving electrodes TE, the sensing electrodes RE, and the dummy patterns DE has a rhombus planar shape, the present disclosure is not limited thereto. For example, each of the driving electrodes TE, the sensing electrodes RE, and the dummy patterns DE may have a quadrilateral shape other than a rhombus shape, a polygonal shape other than a quadrilateral shape, a circular shape, or an elliptical shape in plan view.

Referring to FIG. 7, the sensor lines TSL may be disposed in the sensor peripheral area TPA. The sensor lines TSL may include sensing lines RL connected to the sensing electrodes RE, and driving lines TL connected to the driving electrodes TE. The sensing line RL may be defined as a first sensor line, and the driving line TL may be defined as a second sensor line.

The sensing electrodes RE arranged at one side of the touch sensor area TSA may be connected one-to-one to the sensing lines RL. For example, as shown in FIG. 7, the sensing electrode RE disposed at a right end among the sensing electrodes RE electrically connected in the first direction DR1, may be connected to the sensing line RL. The sensing lines RL may be connected one-to-one to the second sensor pads TP2. Therefore, the touch driving circuit 400 may be electrically connected to the sensing electrodes RE.

The driving electrodes TE arranged at one side of the touch sensor area TSA may be connected one-to-one, to the driving lines TL. For example, as shown in FIG. 7, the driving electrode TE disposed at a lower end among the driving electrodes TE electrically connected in the second direction DR2 may be connected to the driving line TL.

The driving lines TL may be connected one-to-one to the first sensor pads TP1, and thus may be electrically connected to the touch driving circuit 400.

Although not shown in FIG. 7, the driving electrodes TE may be connected to the driving lines TL at both sides of the touch sensor area TSA. In this case, it is possible to prevent a difference between the touch driving signal applied to the driving electrodes TE disposed at the lower side of the touch sensor area TSA and the touch driving signal applied to the driving electrodes TE disposed at the upper side of the touch sensor area TSA due to an RC delay of the touch driving signal.

The first sensor pads TP1 may be arranged at one side of the group of the signal pads SPD connected to the circuit array layer 120 in the pad area PDA of the second sub-region SB2 of the sub-region SBA.

The second sensor pads TP2 may be arranged at the other side of the group of the signal pads SPD connected to the circuit array layer 120 in the pad area PDA of the second sub-region SB2 of the sub-region SBA.

That is, the signal pads SPD connected to the circuit array layer 120 may be arranged at the central portion of the pad area PDA of the second sub-region SB2 of the sub-region SBA, and the first sensor pads TP1 and the second sensor pads TP2 may be arranged at both of opposing sides of the pad area PDA of the second sub-region SB2 of the sub-region SBA.

Some of the signal pads SPD may be connected to the display driving circuit 200 mounted in the second sub-region SB2 of the sub-region SBA, and the first scan driver SDC1 and the second scan driver SDC2 disposed in the non-display area NDA. In addition, others of the signal pads SPD connected to the circuit array layer 120 may be connected to wires supplying power to the display area DPA.

The signal pads SPD, the first sensor pads TP1, and the second sensor pads TP2 may overlap the circuit board 300 (see FIG. 1) electrically connected to the substrate 110, and may be electrically connected by a low-resistance high-reliability material such as SAP or an anisotropic conductive film.

As shown in FIGS. 7 and 8, the sensor electrode layer 150 may include the driving electrodes TE and the sensing electrodes RE in the touch sensor area TSA, and may sense a touch of an object or a person using the mutual capacitance between the driving electrodes TE and the sensing electrodes RE.

Referring to FIG. 9, the driving electrodes TE, the sensing electrodes RE, and the dummy patterns DE may be disposed on the same layer and spaced apart from each other. That is, a gap may be formed between the driving electrode TE and the sensing electrode RE. Further, a gap may be formed between the driving electrode TE and the dummy pattern DE and between the sensing electrode RE and the dummy pattern DE.

The bridge lines BE may be disposed on a different layer from the driving electrodes TE and the sensing electrodes RE.

One side of the bridge line BE may be connected to any one driving electrode TE among the driving electrodes TE adjacent in the second direction DR2 through first touch contact holes TCNT1. The other side of the bridge line BE may be connected to another driving electrode TE among the driving electrodes TE adjacent in the second direction DR2 through the first touch contact holes TCNT1.

Each of the driving electrodes TE, the sensing electrodes RE, and the bridge lines BE may be formed in a mesh structure or a net structure in plan view. Further, each of the dummy patterns DE may also be formed in a mesh structure or a net structure in plan view. Accordingly, the driving electrodes TE, the sensing electrodes RE, the bridge lines BE, and the dummy patterns DE may not overlap the plurality of emission areas EA. As not overlapping, elements may be adjacent to each other and/or spaced apart from each other. Therefore, the decrease in the light emission efficiency due to the driving electrodes TE, the sensing electrodes RE, the bridge lines BE, and the dummy patterns DE may be prevented, thereby preventing the decrease in luminance of the light emitted from the plurality of emission areas EA.

Alternatively, each of the driving electrodes TE, the sensing electrodes RE, the bridge lines BE, and the dummy patterns DE may be formed in an entire surface structure rather than a mesh structure or a net structure in plan view. As an entire surface structure, an element may be disposed on or in an entirety of a planar area, such as the display area DPA, etc. In this case, the respective electrode may overlap or be disposed in the emission areas EA. In order to minimize the decrease in luminance of the light emitted from the plurality of emission areas EA, the driving electrodes TE, the sensing electrodes RE, the bridge lines BE, and the dummy patterns DE may be made of a transparent conductive material, such as ITO or IZO, capable of transmitting light.

The plurality of emission areas EA may include first emission areas EA1 emitting light of a first color, second emission areas EA2 emitting light of a second color, and third emission areas EA3 emitting light of a third color. For example, the first color may be red, the second color may be green, and the third color may be blue.

Each of the first emission areas EA1, the second emission areas EA2, and the third emission areas EA3 may have a rhombus planar shape or a rectangular planar shape. However, this is only an example, and the planar shape of the plurality of emission areas EA according to an embodiment is not limited to that illustrated in FIG. 9. That is, the plurality of emission areas EA may have a polygonal shape other than a quadrangle, a circular shape, or an elliptical shape in plan view. Further, although FIG. 9 illustrates that the third emission area EA3 is largest in planar area and the second emission area EA2 is smallest in planar area, the planar widths (or dimensions) of the plurality of emission areas EA according to an embodiment is not limited to those illustrated in FIG. 9.

A plurality of pixels PX, each including one first emission area EA1, two second emission areas EA2, and one third emission area EA3 adj acent to each other among the plurality of emission areas EA, may be provided. Each of the plurality of pixels PX may be a unit area displaying white light. That is, colored light emitted from one first emission area EA1, colored light emitted from two second emission areas EA2, and colored light emitted from one third emission area EA3 may be combined to express the white gray level of each pixel PX.

The emission areas EA may be arranged in rows extending along the first direction DR1, and in columns extending along the second direction DR2. The second emission areas EA2 may be arranged in odd rows. The second emission areas EA2 may be arranged side by side in the first direction DR1, in each of the odd rows. In an embodiment, the odd rows may include only the second emission areas EA2.

The second emission areas EA2 may have a long side and a short side which has a length smaller than a length of the long side. In each of the odd rows, any one of the second emission areas EA2 adjacent in the first direction DR1 has a long side in one direction and a short side in the other direction, whereas another one has a long side in the other direction and a short side in one direction. One direction may be a direction between the first direction DR1 and the second direction DR2, and the other direction may be a direction intersecting the one direction. That is, among second emission areas EA2 adjacent in the first direction DR1, one second emission area EA2 has the long side extended in one elongation direction and a short side extended in another elongation direction which crosses the one elongation direction, whereas the other second emission area EA2 has a long side extended in the another elongation direction and a short side elongated in the one elongation direction. The one elongation direction may be a direction between the first direction DR1 and the second direction DR2 (e.g., a first Inclined direction), and the another elongation direction may also be a direction between the first direction DR1 and the second direction DR2 but intersecting the one elongation direction (e.g., a second inclined direction).

The first emission areas EA1 and the third emission areas EA3 may be disposed in even rows. The first emission areas EA1 and the third emission areas EA3 may be arranged side by side in the first direction DR1, in each of the even rows. The first emission areas EA1 and the third emission areas EA3 may be alternately arranged in each of the even rows.

The second emission areas EA2 may be arranged in odd columns. The second emission areas EA2 may be arranged side by side in the second direction DR2 in each of the odd columns. In an embodiment, the odd rows may include only the second emission areas EA2. In each of the odd columns, any one of the second emission areas EA2 adjacent in the second direction DR2 has a long side in one direction and a short side in the other direction, whereas another one has a long side in the other direction and a short side in one direction.

The first emission areas EA1 and the third emission areas EA3 may be disposed in even columns. The first emission areas EA1 and the third emission areas EA3 may be arranged side by side in the second direction DR2 in each of the even columns. The first emission areas EA1 and the third emission areas EA3 may be alternately arranged in each of the even columns.

However, this is only an example, and the arrangement of the plurality of emission areas EA according to an embodiment is not limited to that illustrated in FIG. 9 and may be variously changed.

The display device 10 includes insulating layers made of (or including) an organic insulating material to evenly cover a stepped portion formed by underlying components or patterns. The organic insulating material becomes a permeation path for oxygen or moisture and contains gas, so that the oxygen, moisture, and gas from the organic insulating material may cause oxidation of an organic material or oxidation of a metal material that is not blocked from the organic insulating material. The oxidation of the organic material or the oxidation of the metal material may be a factor that rapidly reduces the lifespan of the display device 10.

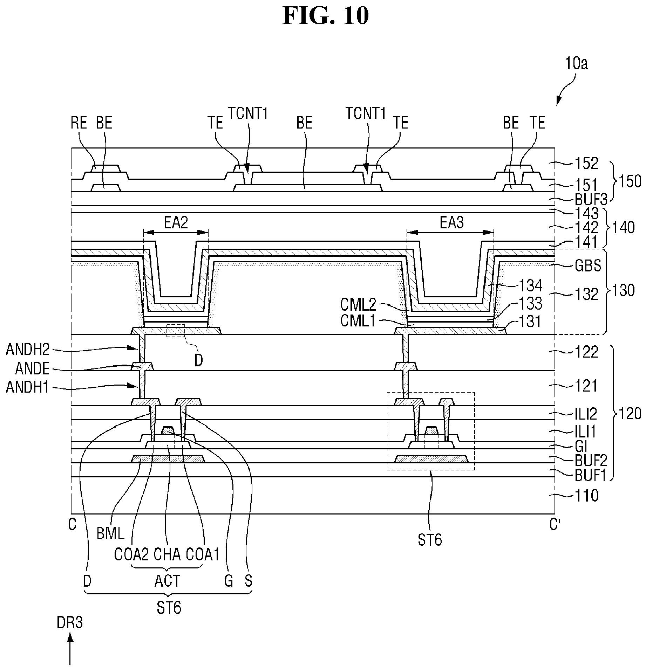

Accordingly, the display device 10 according to an embodiment includes an insulating layer made of an organic insulating material on which a gas blocking surface for blocking an organic material or a metal material from the organic insulating material is disposed. That is, in the display device 10 according to an embodiment, at least one of a first planarization layer 121 (see FIG. 10), a second planarization layer 122 (see FIG. 10) and a pixel defining layer 132 (see FIG. 10) made of an organic insulating material includes (or defines) a gas blocking surface disposed on a surface facing a cathode electrode 134 (see FIG. 10). More than one among the first planarization layer 121, the second planarization layer 122 and the pixel defining layer 132 may together be considered an organic layer, and one or more gas blocking thickness portions may be disposed in such organic layer.

Hereinafter, embodiments according to the arrangement of the gas blocking surface will be described.

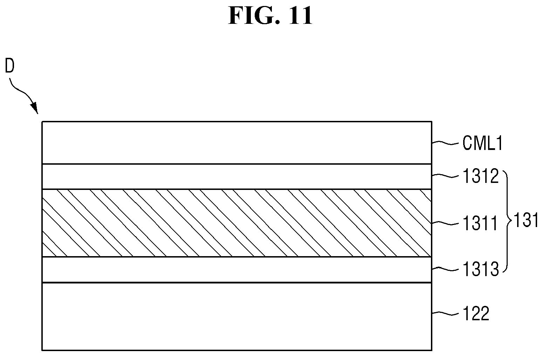

FIG. 10 is a cross-sectional view showing an example of the plane taken along line C-C' of FIG. 9 according to an embodiment. FIG. 11 is a cross-sectional view showing area D of FIG. 10.

Referring to FIG. 10, a display device 10a according to an embodiment includes the substrate 110 including the display area DPA in which the plurality of emission areas EA for displaying an image are arranged, the circuit array layer 120 disposed on the substrate 110 and including the plurality of pixel driving units PD respectively corresponding to the plurality of emission areas EA, and the light emitting array layer 130 disposed on the circuit array layer 120.

The circuit array layer 120 includes the first planarization layer 121 covering two or more transistors DT and ST1 to ST6 (see FIG. 6) included in each of the plurality of pixel driving units PD and made of an organic insulating material, a plurality of anode connection electrodes ANDE disposed on the first planarization layer 121 and respectively connected to the plurality of pixel driving units PD, and the second planarization layer 122 disposed on the first planarization layer 121, covering the plurality of anode connection electrodes ANDE, and made of an organic insulating material.

Here, referring to FIGS. 6 and 10, the plurality of anode connection electrodes ANDE may be respectively connected to the sixth transistors ST6 of the plurality of pixel driving units PD.

The light emitting array layer 130 includes a plurality of anode electrodes 131 disposed on the second planarization layer 122, respectively corresponding to the plurality of emission areas EA, and respectively connected to the plurality of anode connection electrodes ANDE, the pixel defining layer 132 disposed on the second planarization layer 122, corresponding to a non-emission area NEA (see FIG. 9) between the plurality of emission areas EA, and covering the edge (e.g., the outer edge) of each of the plurality of anode electrodes 131, a plurality of light emitting layers 133 respectively disposed on the plurality of anode electrodes 131, and the cathode electrode 134 disposed on the pixel defining layer 132 and the plurality of light emitting layers 133 and corresponding to the plurality of emission areas EA.

Here, the pixel defining layer 132 is made of an organic insulating material, and includes a gas blocking surface GBS disposed on (or at) a surface (top surface of FIG. 10) facing the cathode electrode 134. The top surface may be an outer surface of the pixel defining layer 132. Solid portions of the pixel defining layer 132 may correspond to the non-emission area NEA, while openings of the pixel defining layer 132 which are defined by the solid portions, may correspond to the emission areas EA. The solid portions and the openings may together define portions of the pixel defining layer 132.

The light emitting array layer 130 may further include a first common layer CML1 respectively disposed between the plurality of anode electrodes 131 and the plurality of light emitting layers 133, and a second common layer CML2 disposed between the plurality of light emitting layers 133, and the cathode electrode 134, respectively.

The gas blocking surface GBS of the pixel defining layer 132 may be disposed on the surface of the pixel defining layer 132 that is in contact with the second common layer CML2. That is, the gas blocking surface GBS of the pixel defining layer 132 may be a gas-blocking thickness portion defined extended into the solid portion of the pixel defining layer 132, from a surface of the solid portion of the pixel defining layer 132 which forms an interface with the second common layer CML2. Referring to FIG. 10, for example, the gas-blocking thickness portion illustrated at the gas blocking surface GBS may also extend along the first direction DR1, to define planar areas in a first direction-second direction plane and/or a first-direction-third direction plane, without being limited thereto.

The gas blocking surface GBS may be provided as an area where the content of oxygen is reduced by replacing a carbon-oxygen bond or a carbon-carbon bond with a carbon-nitrogen-oxygen bond or by replacing oxygen with nitrogen by performing nitrogen (N₂) plasma treatment on the surface of the pixel defining layer 132 that is in contact with the second common layer CML2. Accordingly, the gas blocking surface GBS may contain less oxygen than the surface (e.g., bottom surface of FIG. 10) of the pixel defining layer 132 that is in contact with the second planarization layer 122. That is, the gas-blocking thickness portion of the pixel defining layer 132 closest to the gas blocking surface GBS may contain less oxygen than a thickness portion at (or closest to) the surface (e.g., bottom surface of FIG. 10) of the pixel defining layer 132 that is in contact with the second planarization layer 122. Herein, the gas-blocking thickness portion may otherwise referred to as the gas blocking surface GBS.

The gas blocking surface GBS having a relatively small oxygen content, may reduce the transfer of oxygen, moisture, or gas from the pixel defining layer 132 and the first and second planarization layers 121 and 122 disposed thereunder, to each of the second common layer CML2 made of (or including) an organic material and the cathode electrode 134 made of a metal material. Accordingly, the oxidation of the second common layer CML2 and/or the oxidation of the cathode electrode 134 may be delayed and, thus, the lifespan of the display device 10a may be increased.

The plurality of anode connection electrodes ANDE may be respectively connected to the plurality of pixel driving units PD, through a plurality of first anode contact holes ANDH1 penetrating at least the first planarization layer 121.

The plurality of anode electrodes 131 may be respectively connected to the plurality of anode connection electrodes ANDE, through a plurality of second anode contact holes ANDH2 penetrating the second planarization layer 122.

Accordingly, the plurality of anode electrodes 131 may be respectively connected to the plurality of pixel driving units PD.

The substrate 110 may be formed of an insulating material such as a polymer resin. For example, the substrate 110 may be made of polyimide. The substrate 110 may be a flexible substrate which is bendable, foldable and rollable such as to be bent, folded and rolled, respectively.

The circuit array layer 120 includes the plurality of pixel driving units PD.

Each of the plurality of pixel driving units PD may include two or more transistors among DT and ST1 to ST6 of FIG. 6.

Among two or more transistors of DT and ST1 to ST6, at least one transistor ST6 may include a semiconductor layer ACT disposed on the substrate 110, and a gate electrode G disposed on a gate insulating layer GI covering the semiconductor layer ACT.

The first planarization layer 121 may be disposed on interlayer insulating layers II,I1 and II,I2 covering the gate electrode G.

For example, the circuit array layer 120 may include a first buffer layer BUF1 disposed on the substrate 110, a second buffer layer BUF2 covering a light blocking layer BML on the first buffer layer BUF1, a gate insulating layer GI covering the semiconductor layer ACT on the second buffer layer BUF2, a first interlayer insulating layer ILI1 covering a gate electrode G on the gate insulating layer GI, a second interlayer insulating layer ILI2 on the first interlayer insulating layer ILI1, a first planarization layer 121 covering both a first electrode S and a second electrode D on the second interlayer insulating layer ILI2, and a second planarization layer 122 covering the anode connection electrode ANDE on the first planarization layer 121.

The first buffer layer BUF1 and the second buffer layer BUF2 are used for protecting the circuit array layer 120 and the light emitting array layer 130 from moisture permeating through the substrate 110 from outside thereof.

Each of the first buffer layer BUF 1 and the second buffer layer BUF2 may be formed of multiple layers stacked along the thickness direction, in which one or more inorganic layers of a silicon nitride layer, a silicon oxynitride layer, a silicon oxide layer, a titanium oxide layer and/or an aluminium oxide layer are stacked, such as being alternately stacked.

The light blocking layer BML is used for preventing a leakage current of the semiconductor layer ACT due to light incident from the substrate 110. To this end, the light blocking layer BML may overlap at least a channel area CHA of the semiconductor layer ACT on the second buffer layer BUF2. Alternatively, the light blocking layer BML may overlap the entire semiconductor layer ACT (e.g., an entirety of the semiconductor layer ACT).

The light blocking layer BML may be formed as a single layer or multiple layers made of (or including) any one of molybdenum (Mo), aluminium (Al), chromium (Cr), gold (Au), titanium (Ti), nickel (Ni), neodymium (Nd) and copper (Cu) and an alloy thereof. Alternatively, the light blocking layer BML may be an organic layer including a black pigment.

The semiconductor layer ACT may include the channel area CHA where a channel (e.g., an electrical channel) is formed due to a potential difference (e.g., an electrical potential different), and a first electrode area COA1 and a second electrode area COA2 positioned on opposing sides of the channel area CHA in a direction along the substrate 110.

The semiconductor layer ACT may include polycrystalline silicon, monocrystalline silicon, low-temperature polycrystalline silicon, amorphous silicon, or an oxide semiconductor material.

When the semiconductor layer ACT includes polycrystalline silicon or an oxide semiconductor material, the first electrode area COA1 and the second electrode area COA2 may be conductive areas obtained by ion doping.

The gate insulating layer GI may be formed of an inorganic insulating layer of a silicon nitride layer, a silicon oxynitride layer, a silicon oxide layer, a titanium oxide layer, or an aluminium oxide layer.

The gate electrode G on the gate insulating layer GI overlaps the channel area CHA of the semiconductor layer ACT in the third direction DR3.

The gate electrode G may be formed as a single layer or multiple layers made of any one of molybdenum (Mo), aluminium (Al), chromium (Cr), gold (Au), titanium (Ti), nickel (Ni), neodymium (Nd) and copper (Cu) and an alloy thereof.

The first interlayer insulating layer ILI1 covering the gate electrode G may be formed of an inorganic layer, e.g., a silicon nitride layer, a silicon oxynitride layer, a silicon oxide layer, a titanium oxide layer, or an aluminium oxide layer. The first interlayer insulating layer ILI1 may include a plurality of inorganic insulating layers together with each other.

A capacitor electrode (not shown) for implementing a capacitor C1 (see FIG. 6) may be disposed on the first interlayer insulating layer ILI1. For example, the capacitor electrode may at least partially overlap the gate electrode of the driving transistor DT (see FIG. 6) disposed on the gate insulating layer GI in the third direction DR3, thereby providing the capacitor C1 (see FIG. 6). The capacitor electrode may be formed as a single layer or multiple layers made of any one of molybdenum (Mo), aluminium (Al), chromium (Cr), gold (Au), titanium (Ti), nickel (Ni), neodymium (Nd) and copper (Cu) and an alloy thereof.

The second interlayer insulating layer ILI2 on the first interlayer insulating layer ILI1 may be formed of an inorganic insulating layer of a silicon nitride layer, a silicon oxynitride layer, a silicon oxide layer, a titanium oxide layer, or an aluminium oxide layer.

Each of the first electrode S and the second electrode D on the second interlayer insulating layer ILI2 may be formed as a single layer or multiple layers made of any one of molybdenum (Mo), aluminium (Al), chromium (Cr), gold (Au), titanium (Ti), nickel (Ni), neodymium (Nd) and copper (Cu) and an alloy thereof.

The first electrode S may be connected to the first electrode area COA1 of the semiconductor layer ACT through a contact hole penetrating the gate insulating layer GI, the first interlayer insulating layer ILI1, and the second interlayer insulating layer ILI2.

The second electrode D may be connected to the second electrode area COA2 of the semiconductor layer ACT through a contact hole penetrating the gate insulating layer GI, the first interlayer insulating layer ILI1, and the second interlayer insulating layer ILI2.

The first planarization layer 121 covering the first electrode S and the second electrode D may be formed of an organic insulating material such as acryl resin, epoxy resin, phenolic resin, polyamide resin, polyimide resin and the like.

The anode connection electrode ANDE on the first planarization layer 121 may be connected to the second electrode D of the sixth transistor ST6 through the first anode contact hole ANDH1 penetrating the first planarization layer 121.

The anode connection electrode ANDE may be formed as a single layer or multiple layers made of any one of molybdenum (Mo), aluminium (Al), chromium (Cr), gold (Au), titanium (Ti), nickel (Ni), neodymium (Nd) and copper (Cu), and an alloy thereof.

The second planarization layer 122 covering the anode connection electrode ANDE may be formed of an organic layer such as acryl resin, epoxy resin, phenolic resin, polyamide resin, polyimide resin and the like.

Although FIG. 10 illustrates a case where the circuit array layer 120 includes a transistor having a top gate structure including the gate electrode G positioned above the semiconductor layer ACT (e.g., the gate electrode G further from the substrate 110 than the semiconductor layer ACT), the present disclosure is not limited thereto. That is, the circuit array layer 120 may include a transistor having a bottom gate structure in which the gate electrode G is positioned under the semiconductor layer ACT (e.g., the gate electrode G closer to the substrate 110 than the semiconductor layer ACT), or a transistor having a double gate structure in which a gate electrode G is positioned above and under the semiconductor layer ACT to define a plurality of gate electrodes G.

The light emitting array layer 130 disposed on the second planarization layer 122 of the circuit array layer 120, includes the plurality of anode electrodes 131 respectively corresponding to the plurality of emission areas EA, the pixel defining layer 132 corresponding to the non-emission area NEA, the plurality of light emitting layers 133 respectively disposed on the plurality of anode electrodes 131, and the cathode electrode 134 commonly disposed on the pixel defining layer 132 and the plurality of light emitting layers 133.

In addition, the light emitting array layer 130 may further include the first common layer CML1 disposed between the plurality of anode electrodes 131 and the plurality of light emitting layers 133, respectively, and the second common layer CML2 disposed between the plurality of light emitting layers 133 and the cathode electrode 134, respectively.

The plurality of anode electrodes 131 may respectively correspond to the plurality of emission areas EA and may be disposed on the second planarization layer 122.

The plurality of anode electrodes 131 may be respectively connected to the plurality of anode connection electrodes ANDE through the plurality of second anode contact holes ANDH2 penetrating the second planarization layer 122.

Each of the plurality of anode electrodes 131 may have a structure in which a reflective metal material and a transparent conductive material which is disposed on the reflective metal material, are stacked.

Referring to FIG. 11, each of the plurality of anode electrodes 131 may include a main layer 1311 made of a reflective metal material and a cover layer 1312 made of a transparent conductive material and disposed on the main layer 1311. Alternatively, each of the plurality of anode electrodes 131 may further include a support layer 1313 made of a transparent conductive material and disposed under the main layer 1311.

Here, the reflective metal material forming (or included in) the main layer 1311 may be selected as any one of silver (Ag), molybdenum (Mo), titanium (Ti), copper (Cu), aluminium (Al), and an APC alloy. The APC alloy is an alloy of silver (Ag), palladium (Pd) and copper (Cu).

Further, the transparent conductive material forming the cover layer 1312 or the support layer 1313 may be selected from among ITO and IZO.

For example, the plurality of anode electrodes 131 may have a stacked structure of the support layer 1313 made of ITO/the main layer 1311 made of silver (Ag)/the cover layer 1312 made of ITO.

As shown in FIG. 10, the pixel defining layer 132 is disposed on the second planarization layer 122, where solid portions correspond to the non-emission area NEA and cover the edge of each of the plurality of anode electrodes 131.

That is, the solid portions of the pixel defining layer 132 serve to define the plurality of emission areas EA by providing pixel openings to separate the plurality of light emitting layers 133, such that the plurality of light emitting elements LEL respectively corresponding to the plurality of emission areas EA are arranged along the circuit array layer 120.

The solid portions of the pixel defining layer 132 may be formed of an organic insulating material such as acryl resin, epoxy resin, phenolic resin, polyamide resin, polyimide resin and the like.

In accordance with the display device 10a of an embodiment, the gas blocking surface GBS is disposed at the surface (top surface of FIG. 10) of the pixel defining layer 132 which faces (or is closest to) the cathode electrode 134.

The gas blocking surface GBS may be provided as an area (or volume defined by a thickness portion) where the oxygen content is reduced by about 20% or more compared to the other surface of the pixel defining layer 132 adjacent to the second planarization layer 122 (e.g., closest to the second planarization layer 122), such as by performing nitrogen plasma (N₂ plasma) treatment at the top surface of the solid portions of the pixel defining layer 132.

The first common layer CML1 may be disposed on each of the plurality of anode electrodes 131.

For example, the first common layer CML1 may be disposed on a part of each of the plurality of anode electrodes 131 that is surrounded by the pixel defining layer 132. The first common layer CML1 may include a plurality of first common layer patterns arranged along the circuit array layer 120.

The first common layer CML1 may include a hole transport layer made of an organic material having a hole transport property. Alternatively, the first common layer CML1 may further include a hole injection layer disposed between the anode electrode 131 and the hole transport layer along the thickness direction, and made of an organic material having a hole injecting property.

The plurality of light emitting layers 133 may be disposed on the first common layer CML1. The plurality of light emitting layers 133 may include a plurality of light emitting patterns arranged spaced apart from each other along the circuit array layer 120.

That is, the first common layer CML1 may be interposed between each of the plurality of anode electrodes 131, and each of the plurality of light emitting layers 133, respectively.

Similarly to the first common layer CMI,1, the plurality of light emitting layers 133 may be disposed on a part of each of the plurality of anode electrodes 131 that is surrounded by the pixel defining layer 132. However, this is only an example, and the edge of each of the plurality of light emitting layers 133 may be disposed on the pixel defining layer 132.

The plurality of light emitting layers 133 may be made of an organic light emitting material emitting light in response to electron-hole pairs.

The organic light emitting material of the light emitting layer 133 may include a host material and a dopant. The dopant may include a phosphorescent material or a fluorescent material.

The light emitting layer 133 may emit light having a color corresponding to the host material or the dopant.

For example, the host material of the light emitting layers corresponding to the first emission area EA1 emitting a first color among the plurality of light emitting layers 133 may include carbazole biphenyl (CBP) or 1,3-bis (carbazol-9-yl) (mCP).

Further, the dopant of the light emitting layers corresponding to the first emission area EA1 among the plurality of light emitting layers 133 may be selected as any one or more phosphorescent materials selected among bis(1-phenylisoquinoline)acetylacetonate iridium (PIQIr(acac)), bis(1-phenylquinoline)acetylacetonate iridium (PQIr(acac)), tris(1-phenylquinoline)iridium (PQIr), and octaethylporphyrin platinum (PtOEP), and a florescent material including PBD:Eu(DBM)3(Phen) or perylene.

The host material of the light emitting layers corresponding to the second emission area EA2 emitting a second color having a wavelength band lower than that of the first color among the plurality of light emitting layers 133 may include CBP or mCP.

Further, the dopant of the light emitting layers corresponding to the second emission area EA2 emitting a second color having a wavelength band lower than that of the first color among the plurality of light emitting layers 133 may be selected as a phosphorescent material including fac-tris(2-phenylpyridine)iridium (Ir(ppy)3) or a fluorescent material including tris(8-hydroxyquinolino)aluminium (Alq3).

The host material of the light emitting layers corresponding to the third emission area EA3 emitting a third color having a wavelength band lower than the second color among the plurality of light emitting layers 133 may include CBP or mCP.

The dopant of the light emitting layers corresponding to the third emission area EA3 emitting a third color having a wavelength band lower than the second color among the plurality of light emitting layers 133 may be selected as a phosphorescent material including (4,6-F2ppy)2Irpic or L2BD111.

The description of the organic light emitting material of the light emitting layers 133 is only an example, and the material of the plurality of light emitting layers 133 according to an embodiment is not limited to the above description.

The second common layer CML2 may be disposed on the pixel defining layer 132 and the plurality of light emitting layers 133.

The second common layer CML2 may include an electron transport layer made of an organic material having an electron transport property. Alternatively, the second common layer CML2 may further include an electron injection layer disposed between the electron transport layer and the cathode electrode 134 along the thickness direction, and made of an organic material having an electron injecting property.

The cathode electrode 134 may be disposed on the second common layer CML2.

That is, the second common layer CML2 may be interposed between the plurality of light emitting layers 133 and the cathode electrode 134.

The cathode electrode 134 may be made of a transparent conductive material (TCO) such as ITO or IZO.

Alternatively, the cathode electrode 134 may be formed of a transparent conductive material (TCO), or a semi-transmissive conductive material such as magnesium (Mg), silver (Ag), or an alloy of magnesium (Mg) and silver (Ag). When the cathode electrode 134 is formed of a semi-transmissive conductive material, the light emission efficiency can be increased due to a micro-cavity effect.

In addition, the light emitting array layer 130 may further include a capping layer (not shown) disposed on the cathode electrode 134 and furthest from the circuit array layer 120 among layers of the light emitting array layer 130.

In embodiments of the light emitting array layer 130, the light emitting elements LEL, each having a structure including the anode electrode 131 and the cathode electrode 134 facing each other, and the light emitting layer 133 interposed therebetween, may be respectively provided in the plurality of emission areas EA.

The light emitting array layer 130 is covered with the sealing structure 140.

The sealing structure 140 is used for preventing oxygen or moisture from permeating into the light emitting array layer 130, and is used for protecting the circuit array layer 120 and the light emitting array layer 130 from foreign substances such as dust. The sealing structure 140 may have a structure in which an inorganic insulating material and an organic insulating material are stacked. Where there is more than one of an inorganic insulating material and an organic insulating material, the inorganic and organic layers are alternately stacked.

For example, the sealing structure 140 may include a first sealing layer 141 made of an inorganic insulating material and disposed on the circuit array layer 120 to cover the light emitting array layer 130, a second sealing layer 142 made of an organic insulating material and disposed on the first sealing layer 141, and a third sealing layer 143 made of an inorganic insulating material and disposed on the first sealing layer 141 to cover the second sealing layer 142.

Each of the first sealing layer 141 and the third sealing layer 143 may be made of an inorganic insulating material as any one of a silicon nitride layer, a silicon oxynitride layer, a silicon oxide layer, a titanium oxide layer, and an aluminium oxide layer.

The second sealing layer 142 may be formed of an organic insulating material such as acryl resin, epoxy resin, phenolic resin, polyamide resin, polyimide resin and the like.

The sensor electrode layer 150 on the sealing structure 140 may include two types of sensor electrodes, e.g., the driving electrodes TE and the sensing electrodes RE.

The sensor electrode layer 150 may include a third buffer layer BUF3 on the sealing structure 140, the bridge line BE disposed on the third buffer layer BUF3, a first sensor insulating layer 151 covering the bridge line BE, the sensor electrodes TE and RE disposed on the first sensor insulating layer 151, and a second sensor insulating layer 152 covering the sensor electrodes TE and RE.

The third buffer layer BUF3 may be formed of multiple layers in which one or more inorganic layers of a silicon nitride layer, a silicon oxynitride layer, a silicon oxide layer, a titanium oxide layer and an aluminium oxide layer are alternately stacked. The third buffer layer BUF3 may be formed by a lamination process using a flexible material, a spin coating process using a solution-type material, a slit die coating process, or a deposition process. The third buffer layer BUF3 may be omitted.

The bridge line BE may be formed of a single layer containing molybdenum (Mo), titanium (Ti), copper (Cu), or aluminium (Al), or may be formed to have a stacked structure (Ti/Al/Ti) of aluminium and titanium, a stacked structure (ITO/Al/ITO) of aluminium and indium tin oxide (ITO), an Ag-Pd-Cu (APC) alloy, or a stacked structure (ITO/APC/ITO) of APC alloy and ITO.

The first sensor insulating layer 151 may be made of a material having an insulating function and an optical function. The first sensor insulating layer 151 may be formed of an organic layer such as acryl resin, epoxy resin, phenolic resin, polyamide resin, polyimide resin or the like. Alternatively, the first sensor insulating layer 151 may be formed of an inorganic layer, for example, a silicon nitride layer, a silicon oxynitride layer, a silicon oxide layer, a titanium oxide layer, or an aluminium oxide layer.

The first sensor insulating layer 151 may be formed by a lamination process using a flexible material, a spin coating process using a solution-type material, a slit die coating process, or a deposition process.

The driving electrodes TE and sensing electrodes RE may be disposed on the first sensor insulating layer 151.

The driving electrodes TE and the sensing electrodes RE do not overlap the emission areas EA. As not overlapping, elements may be adjacent to each other and/or spaced apart from each other along a planar direction, such as along the light emitting array layer 130. Accordingly, the material of the driving electrodes TE and the sensing electrodes RE is not limited to a transparent conductive material. That is, the driving electrodes TE and the sensing electrodes RE may be formed of a single layer containing molybdenum (Mo), titanium (Ti), copper (Cu), or aluminium (Al), or may be formed to have a stacked structure (Ti/Al/Ti) of aluminium and titanium, a stacked structure (ITO/Al/ITO) of aluminium and indium tin oxide (ITO), an Ag-Pd-Cu (APC) alloy, or a stacked structure (ITO/APC/ITO) of APC alloy and ITO.

The driving electrodes TE and the sensing electrodes RE may be disposed on the same layer, and may be simultaneously formed using the same material.

The second sensor insulating layer 152 may be a layer having an insulating function and an optical function. The second sensor insulating layer 152 may be formed of an organic layer such as acryl resin, epoxy resin, phenolic resin, polyamide resin, polyimide resin or the like. Alternatively, the second sensor insulating layer 152 may further include an inorganic layer disposed above or under the organic layer. The inorganic layer of the second sensor insulating layer 152 may be a silicon nitride layer, a silicon oxynitride layer, a silicon oxide layer, a titanium oxide layer, or an aluminium oxide layer.

The second sensor insulating layer 152 may be formed by a lamination process using a flexible material, a spin coating process using a solution-type material, a slit die coating process, or a deposition process.

Alternatively, the second sensor insulating layer 152 may be made of an insulating material that is laminated in a relatively low temperature environment so as not to damage insulating materials and conductive materials disposed thereunder. For example, the second sensor insulating layer 152 may be made of an organic material of a negative photoresist. That is, the negative photoresist may be deposited even at a temperature of about 90 degrees Celsius (°C), so that it is possible to prevent deformation caused by a high temperature environment.

As described above, in accordance with the embodiment, the gas blocking surface GBS is disposed at the surface of the pixel defining layer 132 that faces the cathode electrode 134 and is in contact with the second common layer CML2.

The gas blocking surface GBS may be provided by performing nitrogen plasma (N₂ plasma) treatment on the surface of the pixel defining layer 132 which is closest to the cathode electrode 134. That is, while the surface of the pixel defining layer 132 is being subjected to the nitrogen plasma (N₂ plasma) treatment, at least a part of each of a carbon-carbon bond (C-C) and a carbon-oxygen bond (C-O, C=O) in the organic insulating material forming the pixel defining layer 132 which is at the surface, is replaced by a carbon-nitrogen-oxygen bond (C-N=O) or a carbon-nitrogen-carbon bond (C=N-C), so that the gas blocking surface GBS may be provided as an area (e.g., volume or thickness portion) in which the oxygen content is reduced by about 20% or more. That is, the oxygen content within the solid portion of the pixel defining layer 132 decreases in a direction toward the common electrode 134, or is lowest at the top surface closest to the common electrode 134.

Due to the gas blocking layer GBS having a relatively low oxygen content, the oxidation rate of a part of the second common layer CML2 that is in contact with the pixel defining layer 132 may decrease. Further, the oxidation of the cathode electrode 134 may also be delayed due to the delay in the oxidation of the second common layer CML2. Therefore, a decrease in the effective width of the emission areas EA due to the oxidation of the second common layer CML2 and the cathode electrode 134 may be prevented, thereby increasing the luminance and lifespan of the display device 10a.

On the other hand, in accordance with the display device 10a of the embodiment, the plurality of anode electrodes 131 are exposed to nitrogen plasma (N₂ plasma) treatment for providing the gas blocking surface GBS of the pixel defining layer 132, so that the transparent conductive material forming the cover layer 1312 of each of the plurality of anode electrodes 131 may be damaged. It is noted that the anode electrodes 131 are exposed to outside the pixel defining layer 132, at the pixel openings between solid portions of the pixel defining layer 132.

That is, while the nitrogen plasma (N₂ plasma) treatment is being performed on the pixel defining layer 132, ions of the reflective metal material forming the main layer 1311 are diffused through a pinhole of the transparent conductive material forming the cover layer 1312 of each of the plurality of anode electrodes 131 and exposed to outside the pixel defining layer 132, so that the transparent conductive material of the cover layer 1312 may be damaged. In this case, it may be difficult to evenly arrange the first common layer CML1 and the light emitting layer 133 on the plurality of anode electrodes 131, in a process subsequent to the plasma treatment process. Accordingly, display quality may deteriorate due to display defects such as dark spots or the like.

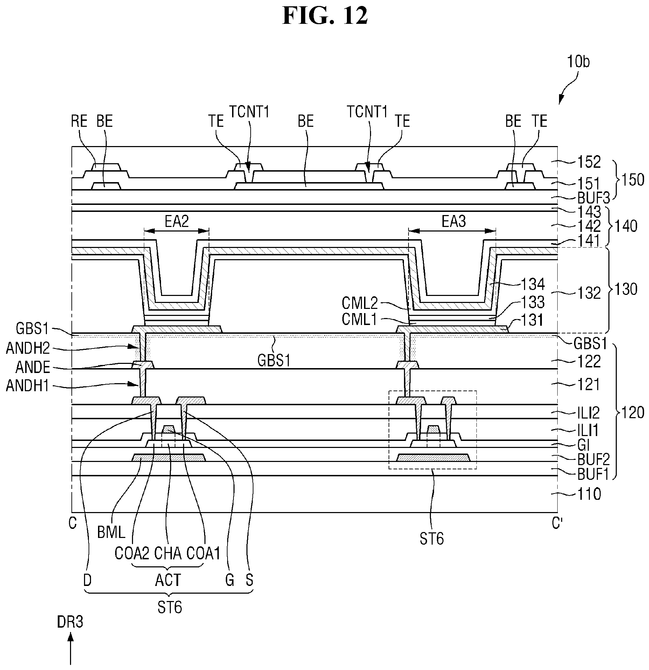

FIGS. 12 to 17 are cross-sectional views respectively showing display devices taken along line C-C' of FIG. 9 according to embodiments.

Referring to FIG. 12, a display device 10b according to the embodiment is substantially the same as the embodiment of FIGS. 10 and 11 except that a first gas blocking surface GBS1 is not defined by the pixel defining layer 132 but is defined by the second planarization layer 122, so that the redundant description will be omitted in the following description.

In accordance with the display device 10b of the embodiment, the first gas blocking surface GBS1 may be disposed at the surface of the second planarization layer 122 that is closest to the light emitting array layer 130, from surfaces within the circuit array layer 120.

That is, the first gas blocking surface GBS1 may be disposed on (or may define) the surface of the second planarization layer 122 that is in contact with the plurality of anode electrodes 131 and the pixel defining layer 132.

The plurality of anode electrodes 131 are connected to the plurality of anode connection electrodes ANDE through the plurality of second anode contact holes ANDH2 penetrating the second planarization layer 122, respectively.

Accordingly, the first gas blocking surface GBS1 may be further disposed on the surface of the second planarization layer 122 that is in contact with the plurality of anode contact holes ANDH2. That is, the first gas blocking surface GBS1 may be a sidewall of the second planarization layer 122 which defines the plurality of anode contact holes ANDH2.

The first gas blocking surface GBS1 may be provided by performing nitrogen plasma (N₂ plasma) treatment on the surface of the second planarization layer 122 on which the plurality of anode connection electrodes ANDE are arranged. That is, while the surface of the second planarization layer 122 is being subjected to the nitrogen plasma (N₂ plasma) treatment, at least a part of each of a carbon-carbon bond (C-C) and a carbon-oxygen bond (C-O, C=O) in the organic insulating material forming the second planarization layer 122 is replaced by a carbon-nitrogen-oxygen bond (C-N=O) or a carbon-nitrogen-carbon bond (C=N-C), so that the gas blocking surface GBS1 may be provided as an area in which the oxygen content is reduced by about 20% or more.

Due to the first gas blocking surface GBS1 having a relatively low oxygen content, the influence of moisture, oxygen, and gas from the first planarization layer 121 and the second planarization layer 122 on the second common layer CML2 and the cathode electrode 134 may be reduced. Accordingly, the oxidation of the second common layer CML2 and the cathode electrode 134 may be delayed, thereby increasing the luminance and lifespan of the display device 10b.

Further, the first gas blocking surface GBS1 is disposed on the second planarization layer 122 under the plurality of anode electrodes 131, so that the plurality of anode electrodes 131 are not exposed to the nitrogen plasma (N₂ plasma) treatment for providing the first gas blocking surface GBS1.

Therefore, damage to the plurality of anode electrodes 131 is prevented, thereby preventing misalignment of the first common layer CML1 and the light emitting layer 133 on the plurality of anode electrodes 131. Accordingly, the display quality of the display device 10b may be improved.

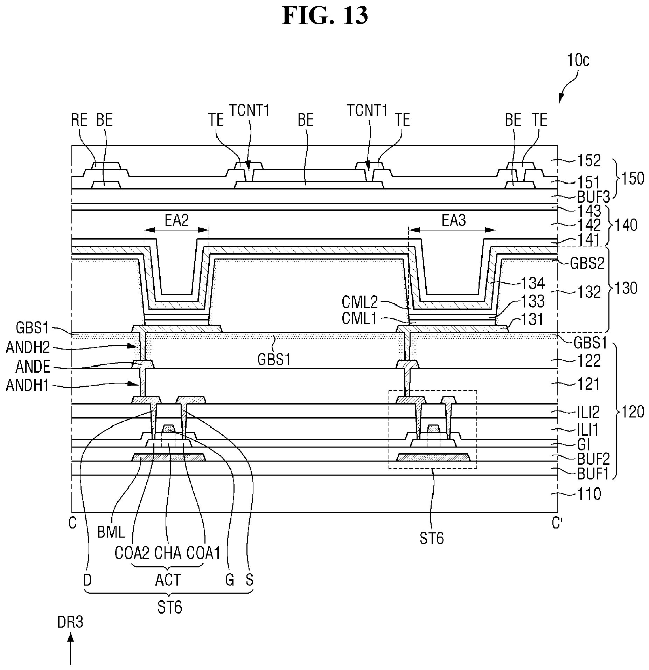

Referring to FIG. 13, a display device 10c according to an embodiment is the same as the display device 10a according to the embodiment and the display device 10b according to the embodiment illustrated in FIGS. 10 to 12 except that it includes the first gas blocking surface GBS1 (e.g., a first gas blocking thickness portion) disposed on the surface of the second planarization layer 122 and a second gas blocking surface GBS2 (e.g., a second gas blocking thickness portion) disposed on the surface of the pixel defining layer 132, so that the redundant description will be omitted in the following description.

In accordance with the display device 10c of the embodiment, the second gas blocking surface GBS2 of the pixel defining layer 132 may have a thickness smaller than that of the first gas blocking surface GBS1 of the second planarization layer 122. That is, a first thickness defined by the second gas blocking surface GBS2 may be smaller than a second thickness defined by the first gas blocking surface GBS1. The various thicknesses may be taken in a direction normal (or perpendicular) to the outer surface of the respective layer which includes the thicknesses.

That is, moisture, oxygen, and gas from the first planarization layer 121 and the second planarization layer 122 may be blocked by the first gas blocking surface GBS1 of the second planarization layer 122, so that the second gas blocking surface GBS2 of the pixel defining layer 132 may have a relatively small thickness that is enough to block the oxygen, moisture, or gas from the pixel defining layer 132. That is, since the larger gas blocking thickness portion of the second planarization layer 122 is disposed before the pixel defining layer 132 in a gas blocking direction (e.g., from the substrate 110 toward the light emitting array layer 130) to provide a primary gas-blocking function, the gas blocking thickness portion of the pixel defining layer 132 may be smaller as a secondary gas-blocking function.

Accordingly, the nitrogen plasma (N₂ plasma) treatment for the pixel defining layer 132 having the smaller gas blocking thickness portion may be performed relatively weakly for a relatively short process time, so that the possibility of damage to the plurality of anode electrodes 131 may be reduced.

Further, the first gas blocking surface GBS1 may reduce the influence of moisture, oxygen, and gas from the first planarization layer 121 and the second planarization layer 122 on the second common layer CML2 and the cathode electrode 134, and the second gas blocking surface GBS2 may block moisture, oxygen, and gas from the pixel defining layer 132. Accordingly, it is possible to considerably reduce the influence of moisture, oxygen, and gas from the first planarization layer 121, the second planarization layer 122, and the pixel defining layer 132 made of an organic insulating material on the oxidation of the second common layer CML2 and the cathode electrode 134, thereby increasing the luminance and lifespan of the display device 10c.

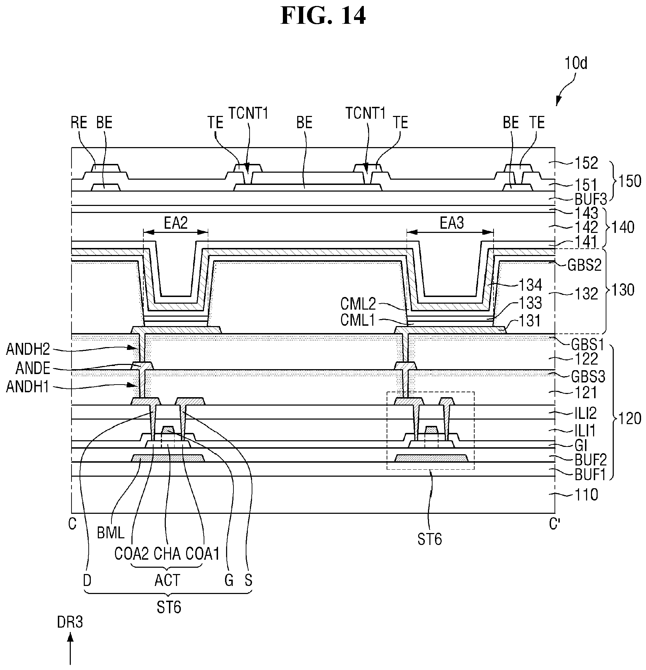

Referring to FIG. 14, a display device 10d according to an embodiment is substantially the same as the display device 10c according to the embodiment of FIG. 13 except that it further includes a third gas blocking surface GBS3 (e.g., a third gas blocking thickness portion) disposed on the surface of the first planarization layer 121 that is in contact with the second planarization layer 122, so that the redundant description will be omitted.

In accordance with the display device 10d of the embodiment, the first, second, and third gas blocking surfaces GBS1, GBS2, and GBS3 are included, so that it is possible to more reliably block moisture, oxygen, and gas from the first planarization layer 121, the second planarization layer 122, and the pixel defining layer 132. That is, the gas blocking thickness portion of the display device 10d includes a plurality of oxygen-reduced thickness portions spaced apart from each other along the thickness direction of the display device 10d. The gas blocking thickness portion of the display device 10d is defined by a plurality of layers each having an oxygen-reduced thickness portion extending from (or defining) a respective top surface of such plurality of layers. Among a plurality of gas blocking thickness portions each having a thickness, thicknesses of the gas blocking thickness portions decrease as the layer is closer to the light emitting array layer 130.

FIGS. 10, 12, 13 and 14 illustrate a case in which the plurality of transistors DT and ST1 to ST6 provided in each of the plurality of pixel driving units PD of the circuit array layer 120 have a top gate structure, and the circuit array layer 120 includes the first and second planarization layers 121 and 122.

However, the circuit array layer 120 of this specification is not limited to those of the display devices 10a to 10d according to the embodiments.

That is, the circuit array layer 120 may include three or more planarization layers, or may include two or more semiconductor layers disposed on (or in) different layers from each other.

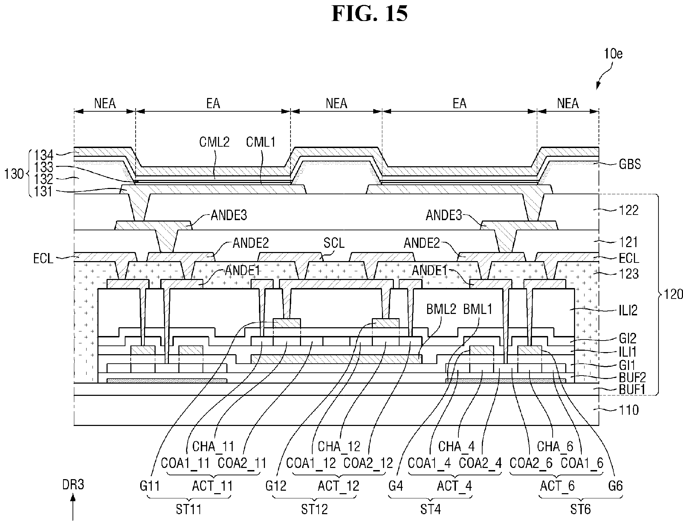

The embodiments illustrated in FIGS. 15 to 17 exemplify the circuit array layer 120 having different structures, respectively.

Referring to FIG. 15, a display device 10e according to the embodiment is substantially the same as the display device 10a according to the embodiment illustrated in FIGS. 10 and 11 except that the circuit array layer 120 includes semiconductor layers ACT_4 and ACT_6 disposed on the second buffer layer BUF2, and semiconductor layers ACT_11 and ACT_12 disposed on the first interlayer insulating layer ILI1, and further includes an auxiliary planarization layer 123 disposed between the second interlayer insulating layer ILI2 and the first planarization layer 121, so that the redundant description will be omitted in the following description.

A first semiconductor layer including semiconductor patterns ACT_4 and ACT_6, may respectively include the channel areas CHA_4 and CHA_6. The semiconductor layer may further include first electrode areas COA1_4 and COA1_6 and second electrode areas COA2_4 and COA2_6 positioned on opposing sides of the respective channel areas, respectively. A second semiconductor layer including semiconductor patterns ACT_11 and ACT_12, may respectively include the channel areas CHA_4 and CHA_6. The semiconductor layer may further include first electrode areas COA1_4 and COA1_6 and second electrode areas COA2_4 and COA2_6 positioned on opposing sides of the respective channel areas, respectively.

In accordance with the display device 10e of the embodiment, among two or more transistors DT and ST1 to ST6 included in each of the plurality of pixel driving units PD of the circuit array layer 120, each of one or more transistors DT, ST2, ST4 to ST6 may include a first semiconductor layer made of a silicon semiconductor and disposed on the second buffer layer BUF2, and at least one of other transistors ST1 and ST3 may include a second semiconductor layer made of an oxide semiconductor and disposed on the first interlayer insulating layer II,I1.

That is, the circuit array layer 120 of the display device 10e according to the embodiment may include a first light blocking layer BMI,1 disposed on the first buffer layer BUF1 covering the substrate 110, the semiconductor layers ACT_4 and ACT_6 of the fourth and sixth transistors ST4 and ST6 that are disposed on the second buffer layer BUF2 covering the first light blocking layer BML1 while overlapping the first light blocking layer BML1 and formed as the first semiconductor layers made of a silicon semiconductor, a second light blocking layer BML2 and gate electrodes G4 and G6 of the fourth and sixth transistors ST4 and ST6 that are formed as first gate electrode layers (e.g., patterns of a first gate electrode layer) on the first gate insulating layer GI1 covering the first semiconductor layers ACT_4 and ACT_6, semiconductor layers ACT_11 and ACT_12 of first and second sub-transistors ST11 and ST12 of the first transistor ST1 that are disposed on the first interlayer insulating layer ILI1 covering the first gate electrode layers G4, G6, and BML2 and formed as second semiconductor layers made of an oxide semiconductor, gate electrodes G11 and G12 of the first and second sub-transistors ST11 and ST12 that are formed as second gate electrode layers (e.g., patterns of a second gate electrode layer) on the second gate insulating layer GI2 covering the second semiconductor layers ACT_11 and ACT_12, a first anode connection electrode ANDE1 disposed on the second interlayer insulating layer ILI2 covering the second gate electrode layers G11 and G12, the auxiliary planarization layer 123 covering the first anode connection electrode ANDE1 and made of an organic insulating material, a second anode connection electrode ANDE2 disposed on the auxiliary planarization layer 123 and connected to the first anode connection electrode ANDE1, the first planarization layer 121 covering the second anode connection electrode ANDE2, a third anode connection electrode ANDE3 disposed on the first planarization layer 121 and connected to the second anode connection electrode ANDE2, and the second planarization layer 122 covering the third anode connection electrode ANDE3.

The auxiliary planarization layer 123 may be in contact with the substrate 110 in a groove corresponding to the boundary between the plurality of pixels PX. Here, the groove filled with the auxiliary planarization layer 123 may be spaced apart from lines (e.g., a conductive line or a signal line) formed as the first gate electrode layer on the first gate insulating layer GI1 and the second gate electrode layer on the second gate insulating layer GI2. Referring to FIG. 15, for example, the first buffer layer BUF1 and the substrate 110 may together be considered a "base substrate." A boundary between pixels PX may be disposed at the left and right sides of the emission areas EA shown in FIG. 15. Here, the layers above the first buffer layer BUF1 through at least the second interlayer insulating layer II,I2, include sidewalls which define a groove. As shown in FIG. 15, the auxiliary planarization layer 123 extends from above such layers within the emission areas EA and into the groove, to fill the groove. The auxiliary planarization layer 123 contacts the base substrate (e.g., 110 together with BUF1).

In accordance with the display device 10e of the embodiment, the gas blocking surface GBS is disposed on the surface of the pixel defining layer 132 facing the cathode electrode 134. Since the gas blocking surface GBS of the pixel defining layer 132 of the display device 10e according to the embodiment is substantially the same as that of the display device 10a according to the embodiment illustrated in FIG. 10, the redundant description will be omitted.

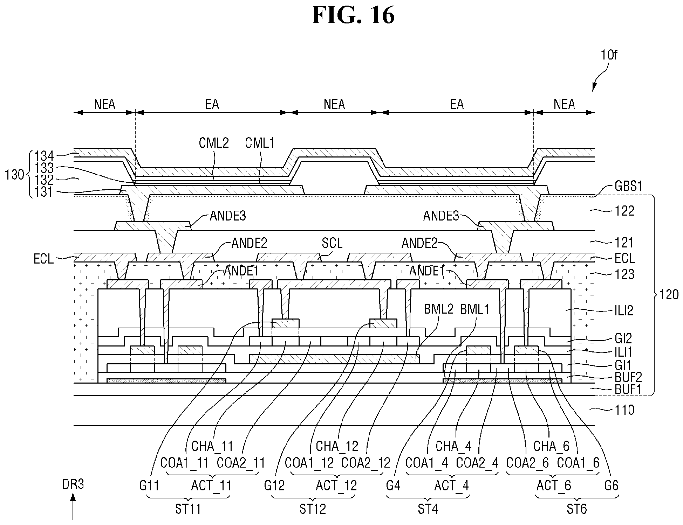

Referring to FIG. 16, a display device 10f according to the embodiment is substantially the same as the display device 10e according to the embodiment illustrated in FIG. 15 except that the first gas blocking surface GBS1 is disposed not on the pixel defining layer 132 but on the second planarization layer 122. The first gas blocking surface GBS1 of the second planarization layer 122 is substantially the same as that of the display device 10b according to the embodiment illustrated in FIG. 12, so that the redundant description will be omitted.

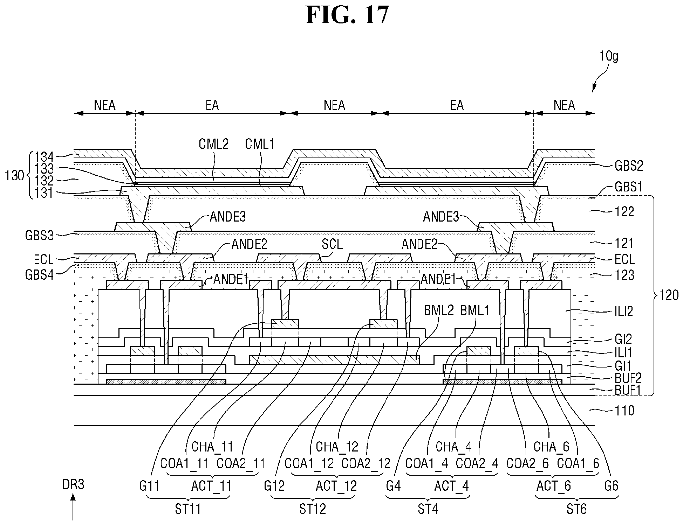

Referring to FIG. 17, a display device 10g according to the embodiment is substantially the same as the display device 10f according to the embodiment illustrated in FIG. 16 except that it further includes the second gas blocking surface GBS2 of the pixel defining layer 132, a third gas blocking surface GBS3 disposed on the surface of the first planarization layer 121 that is in contact with the second planarization layer 122, and a fourth gas blocking surface GBS4 (e.g., a fourth gas blocking thickness portion) disposed on the surface of the auxiliary planarization layer 123 that is in contact with the first planarization layer 121, so that the redundant description will be omitted.

A method for manufacturing (or providing) one or more of the display devices 10a to 10d according to the embodiments will be described.

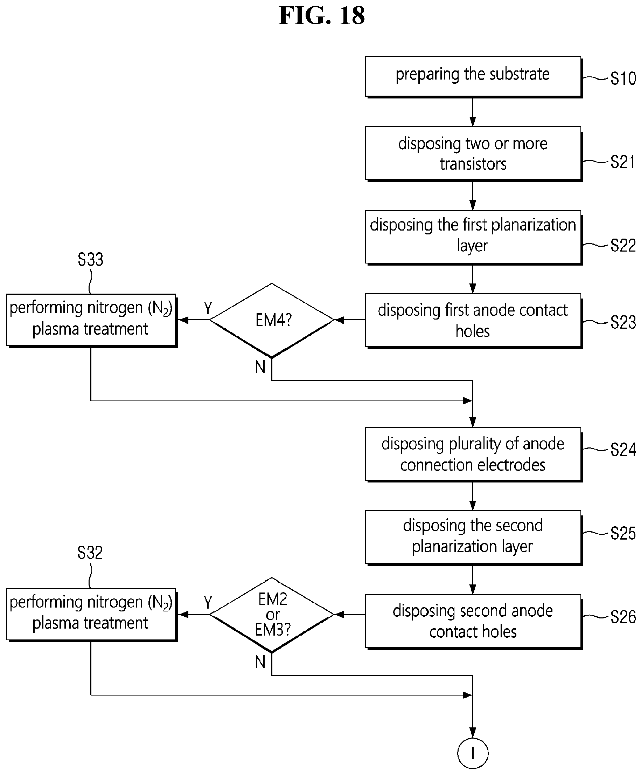

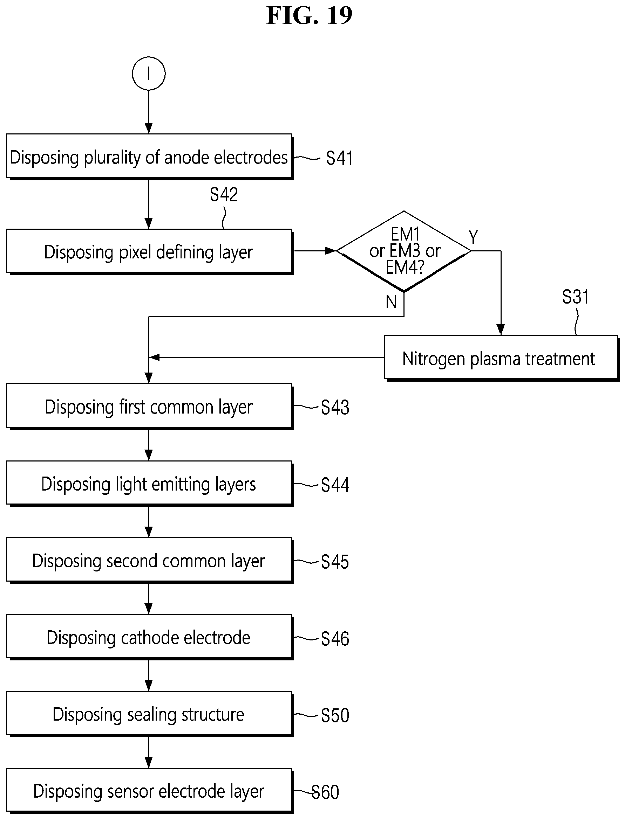

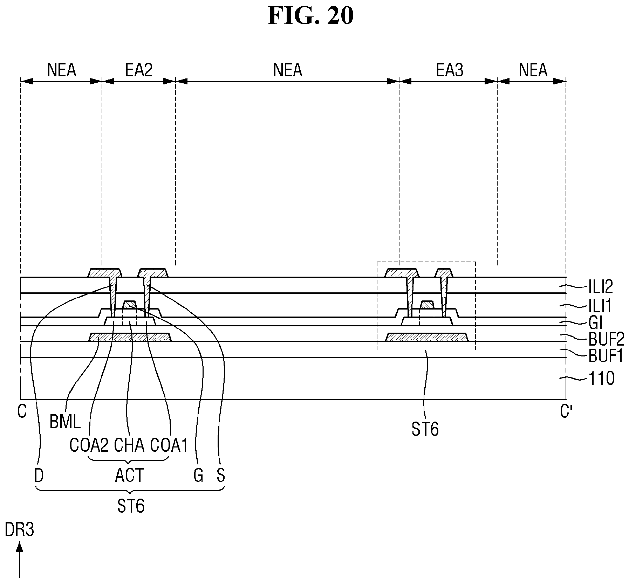

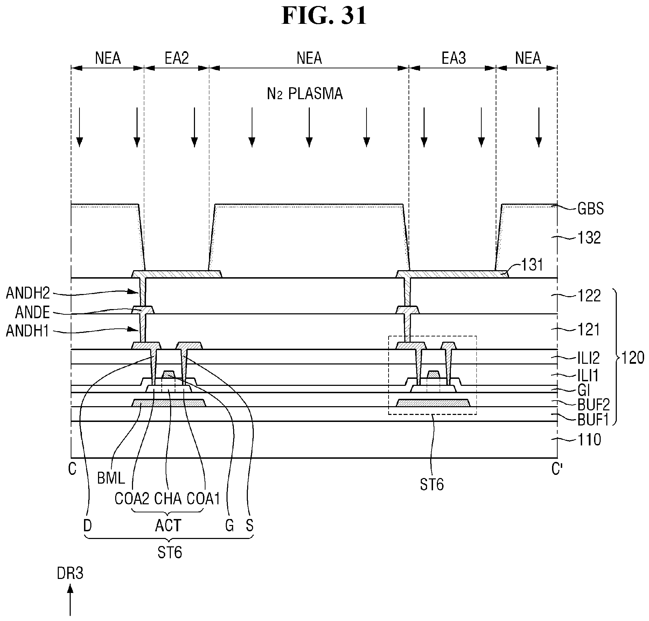

FIGS. 18 and 19 are flowcharts illustrating the method for manufacturing display devices according to the embodiments. FIGS. 20 to 37 are cross-sectional views of structures related to the processes shown in FIGS. 18 and 19. FIGS. 20 to 37 may correspond to views along C-C' in FIG. 9.

Referring to FIG. 18, the method for manufacturing the display devices 10a to 10d according to the embodiments includes preparing the substrate 110 including the display area DPA in which the plurality of emission areas EA for displaying an image are arranged (S10), disposing two or more transistors DT and ST1 to ST6 included in each of the plurality of pixel driving units PD respectively corresponding to the plurality of emission areas EA on the substrate 110 (S21), disposing the first planarization layer 121 made of an organic insulating material and covering two or more transistors DT and ST1 to ST6 included in each of the plurality of pixel driving units PD (S22), disposing the plurality of anode connection electrodes ANDE respectively connected to the plurality of pixel driving units PD on the first planarization layer 121 (S24), disposing the second planarization layer 122 made of an organic insulating material and covering the plurality of anode connection electrodes ANDE on the first planarization layer 121 (S25), disposing the plurality of anode electrodes 131 respectively corresponding to the plurality of emission areas EA and respectively connected to the plurality of anode connection electrodes ANDE on the second planarization layer 122 (S41), disposing the pixel defining layer 132 corresponding to the non-emission area NEA between the plurality of emission areas EA, covering the edge of each of the plurality of anode electrodes 131, and made of an organic insulating material on the second planarization layer 122 (S42), disposing the plurality of light emitting layers 133 respectively corresponding to the plurality of emission areas EA on the plurality of anode electrodes 131 (S44), and disposing the cathode electrode 134 corresponding to the plurality of emission areas EA on the pixel defining layer 132 and the plurality of light emitting layers 133 (S46).

The method for manufacturing the display devices 10a to 10d according to the embodiments further includes providing the gas blocking surfaces GBS, GBS1, GBS2, and GBS3 by performing nitrogen (N₂) plasma treatment (steps S31, S32, and S33) after at least one of the disposing of the first planarization layer 121 (S22), the disposing of the second planarization layer 122 (S25), and the disposing of the pixel defining layer 132 (S42).

The method for manufacturing the display devices 10a to 10d according to the embodiments may further include disposing the first common layer CML1 including the hole transport layer made of an organic material having a hole transport property on the plurality of anode electrodes 131 (S43) before the disposing of the plurality of light emitting layers 133 (S44).

The method for manufacturing the display devices 10a to 10d according to the embodiments may further include disposing the second common layer CML2 including the electron transport layer made of an organic material having an electron transport property on the pixel defining layer 132 and the plurality of light emitting layers 133 (S45) before the disposing of the cathode electrode 134 (S46).

Referring to FIG. 20, the substrate 110 including the display area DPA in which the plurality of emission areas EA (EA1 and EA2) are arranged is provided (S10), and two or more transistors DT and ST1 to ST6 included in the plurality of pixel driving units PD are arranged on the substrate 110 (S21).

The disposing of two or more transistors DT and ST1 to ST6 (S21) may include a process of disposing the light blocking layer BML on the first buffer layer BUF1 covering the substrate 110, a process of disposing the second buffer layer BUF2 covering the light blocking layer BML, a process of disposing the gate insulating layer GI covering the semiconductor layer ACT on the second buffer layer BUF2, a process of disposing the first interlayer insulating layer ILI1 covering the gate electrode G on the gate insulating layer GI, a process of disposing the second interlayer insulating layer ILI2 covering the first interlayer insulating layer ILI1, a process of disposing a contact hole corresponding to a part of each of the first and second electrode areas COA1 and COA2 of the semiconductor layer ACT, and a process of disposing the first electrode S and the second electrode D on the second interlayer insulating layer ILI2.

Accordingly, two or more transistors DT and ST1 to ST6, each including the semiconductor layer ACT, the gate electrode G, the first electrode S, and the second electrode D, may be provided.

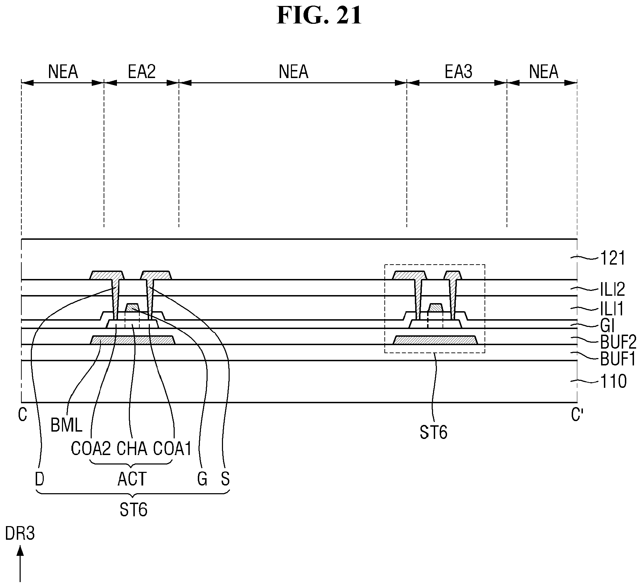

Referring to FIG. 21, the first planarization layer 121 is disposed to evenly cover two or more transistors DT and ST1 to ST6 (S22).

The first planarization layer 121 may be made of an organic insulating material such as acryl resin, epoxy resin, phenolic resin, polyamide resin, polyimide resin, or the like.

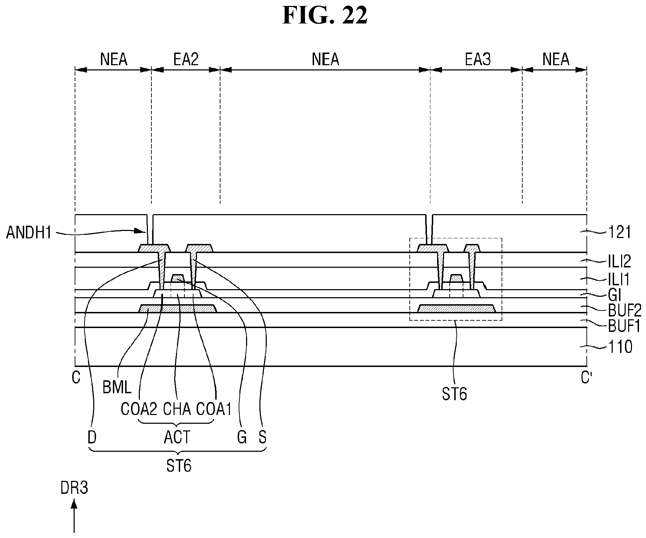

Referring to FIG. 22, the first anode contact holes ANDH1 corresponding to a part of each of the plurality of pixel driving units PD and penetrating the first planarization layer 121 are disposed (S23).

For example, a part of each of the plurality of pixel driving units PD may be selected as a part of the second electrode D of the sixth transistor ST6 or a part of the second electrode of the fourth transistor ST4.

The disposing of the first anode contact holes ANDH1 (S23) may include a process of removing a part of the first planarization layer 121 corresponding to a part of each of the plurality of pixel driving units PD, such as by using a predetermined etching material.

Alternatively, the disposing of the first anode contact holes ANDH1 (S23) may include a process of removing at least a part of the first planarization layer 121 corresponding to a part of each of the plurality of pixel driving units PD by using a predetermined etching material, and a process of removing the residue of the first planarization layer 121 remaining on a part of each of the plurality of pixel driving units PD using oxygen (O₂) plasma.

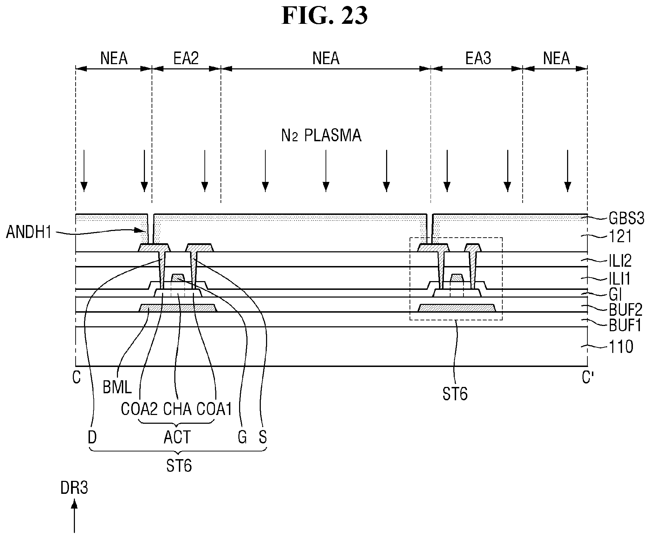

Referring to FIG. 23, in the case of the method for manufacturing the display device 10d according to the embodiment (EM4? - Y), the disposing of the third gas blocking surface GBS3 on the surface of the first planarization layer 121 by performing nitrogen (N₂) plasma treatment on the first planarization layer 121 (S33) may be further included after the disposing of the plurality of first anode contact holes ANDH1 (S23).

At this time, while the nitrogen (N₂) plasma treatment is being performed, at least a part of each of a carbon-carbon bond (C-C) and a carbon-oxygen bond (C-O, C=O) adjacent to the top surface of the first planarization layer 121 is replaced by a carbon-nitrogen-oxygen bond (C-N=O) or a carbon-nitrogen-carbon bond (C=N-C), so that the third gas blocking surface GBS3 as a thickness portion where the oxygen content is lower by about 20% or more compared to other portions of the first planarization layer 121, may be provided at the surface of the first planarization layer 121.

By performing the nitrogen (N₂) plasma treatment at the surface of the first planarization layer 121, the third gas blocking surface GBS3 for blocking oxygen, moisture and gas from the first planarization layer 121 may be provided and, also, the organic material may be removed from a part of each of the plurality of pixel driving units PD exposed by the plurality of first anode contact holes ANDH1, thereby improving the reliability of electrical connection through the plurality of first anode contact holes ANDH1. That is, the third gas blocking surface GBS3 may be provided having a depth from the top surface of the first planarization layer 121, together with a portion of the organic material being removed corresponding to a part of each of the plurality of pixel driving units PD exposed to outside the first planarization layer 121 by the plurality of first anode contact holes ANDH1, thereby improving the reliability of electrical connection through the plurality of first anode contact holes ANDH1.

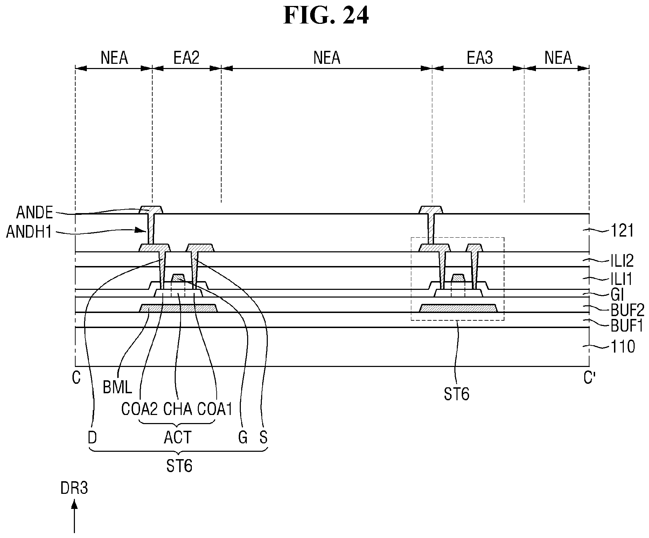

Referring to FIG. 24, in the case of the method other than the method for manufacturing the display device 10d according to the embodiment (EM4? - N), after the disposing of the plurality of first anode contact holes ANDH1 (S23), the plurality of anode connection electrodes ANDE are arranged on the first planarization layer 121 (S24).

The plurality of anode connection electrodes ANDE may be connected to the plurality of pixel driving units PD through the plurality of first anode contact holes ANDH1, respectively.

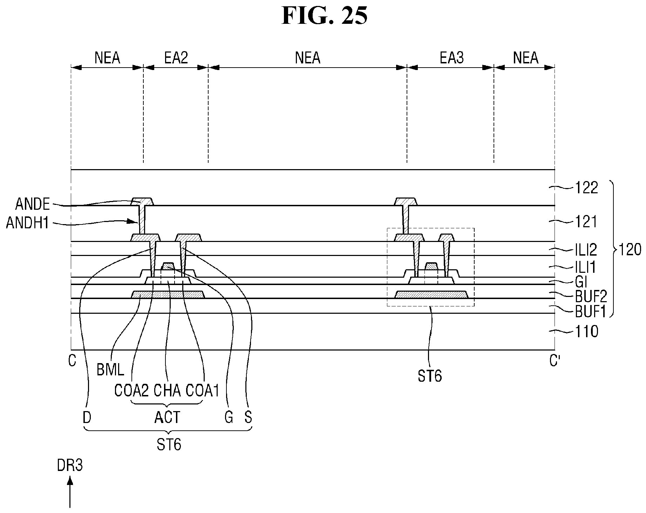

Referring to FIG. 25, the second planarization layer 122 that evenly covers the plurality of anode connection electrodes ANDE is disposed (S25).

The second planarization layer 122 may be formed of an organic insulating material such as acryl resin, epoxy resin, phenolic resin, polyamide resin, polyimide resin and the like.

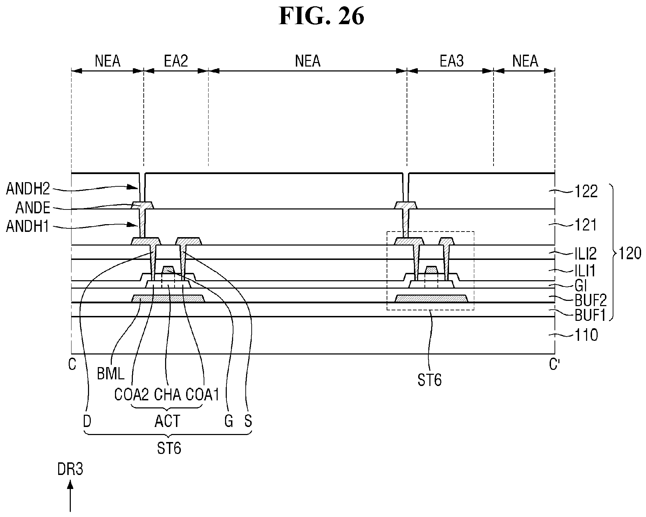

Referring to FIG. 26, the second anode contact holes ANDH2 corresponding to a part of each of the plurality of anode connection electrodes ANDE and penetrating the second planarization layer 122 are disposed (S26).

The disposing of the second anode contact holes ANDH2 (S26) may include a process of removing a part of the second planarization layer 122 corresponding to a part of each of the plurality of anode connection electrodes ANDE, using a predetermined etching material.

Alternatively, the disposing of the second anode contact holes ANDH2 (S26) may include a process of removing a part of the second planarization layer 122 corresponding to a part of each of the plurality of anode connection electrodes ANDE, and a process of removing the residue of the second planarization layer 122 remaining on a part of each of the anode connection electrodes ANDE, using oxygen (O₂) plasma.

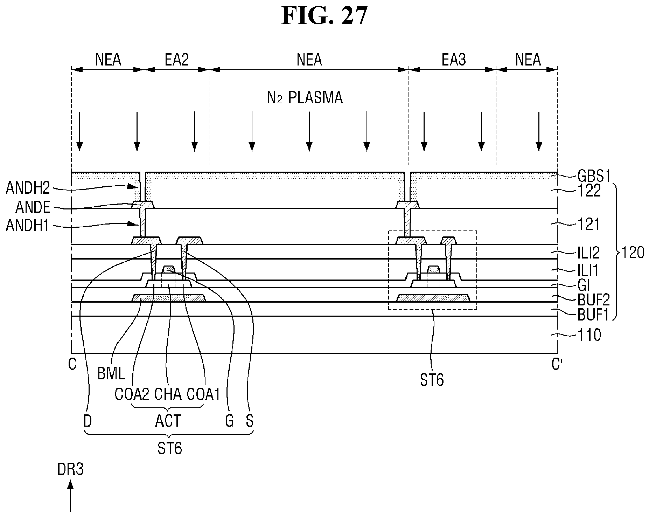

Referring to FIG. 27, in the case of the method for manufacturing the display device 10b according to the embodiment or the method for manufacturing the display device 10c according to the embodiment (EM2 OR EM3? - Y), the disposing of the first gas blocking surface GBS1 on the surface of the second planarization layer 122 by performing nitrogen (N₂) plasma treatment on the second planarization layer 122 (S32) may be further included after the disposing of the plurality of second anode contact holes ANDH2 (S26).

At this time, while the nitrogen (N₂) plasma treatment is being performed, at least a part of each of a carbon-carbon bond (C-C) and a carbon-oxygen bond (C-O, C=O) on the surface of the second planarization layer 122 is replaced by a carbon-nitrogen-oxygen bond (C-N=O) or a carbon-nitrogen-carbon bond (C=N-C), so that the first gas blocking surface GBS 1 where the oxygen content is lower by about 20% or more compared to other portions of the second planarization layer 122 may be provided on the surface of the second planarization layer 122.

By performing the nitrogen (N₂) plasma treatment on the surface of the second planarization layer 122, the first gas blocking surface GBS1 for blocking oxygen, moisture and gas from the second planarization layer 122 may be provided together with a portion of an organic material may be removed from a part of each of the plurality of anode connection electrodes ANDE exposed by the plurality of second anode contact holes ANDH2, thereby improving the reliability of electrical connection through the plurality of second anode contact holes ANDH2.

Accordingly, the circuit array layer 120 is provided, including a gas blocking thickness portion.

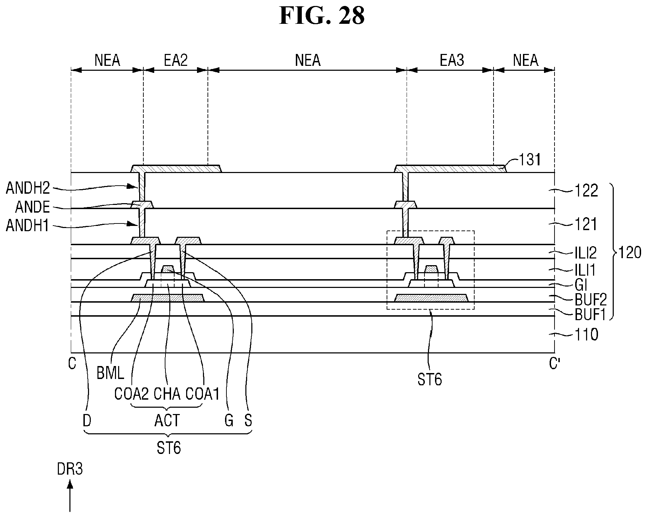

Referring to FIG. 28, in the case of the method other than the method for manufacturing the display device 10b according to the embodiment or the method for manufacturing the display device 10c according to the embodiment (EM2 OR EM3? - N), after the disposing of the plurality of second anode contact holes ANDH2 (S26), the plurality of anode electrodes 131 are disposed on the second planarization layer 122 (S41).

The plurality of anode electrodes 131 may be connected to the plurality of anode connection electrodes ANDE, through (or at) the plurality of second anode contact holes ANDH2, respectively.

Each of the plurality of anode electrodes 131 may include the main layer 1311 made of a reflective metal material and the cover layer 1312 made of a transparent conductive material and disposed on the main layer 1311. Alternatively, each of the plurality of anode electrodes 131 may further include the support layer 1313 made of a transparent conductive material and disposed under the main layer 1311.

The reflective metal material forming the main layer 1311 may be selected as any one of silver (Ag), molybdenum (Mo), titanium (Ti), copper (Cu), aluminium (Al), and an APC alloy.

The transparent conductive material forming the cover layer 1312 or the support layer 1313 may be selected as ITO or IZO.

For example, the plurality of anode electrodes 131 may have a stacked structure of the support layer 1313 made of ITO/the main layer 1311 made of silver (Ag)/the cover layer 1312 made of ITO.

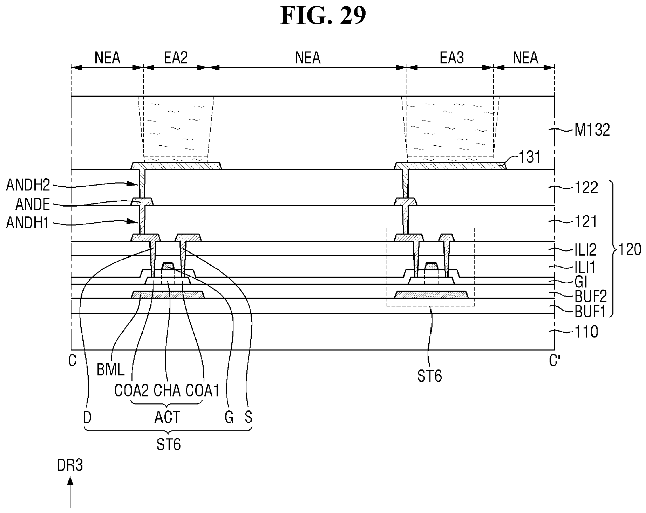

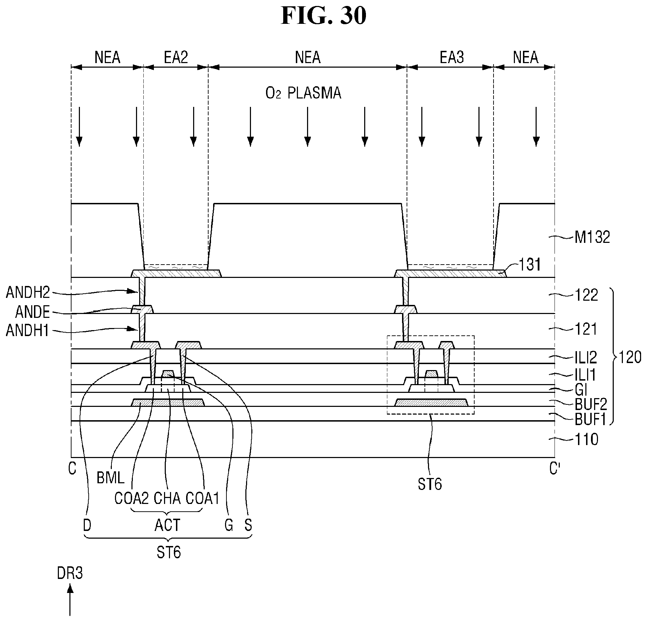

Referring to FIGS. 29 and 30, the pixel defining layer 132 corresponding to the non-emission area NEA is disposed (S42).

The disposing of the pixel defining layer 132 (S42) may include a process of disposing an organic insulating material layer M132 that evenly covers the plurality of anode electrodes 131 on the second planarization layer 122, and a process of providing the pixel defining layer 132 by removing a part of the organic insulating material layer M132 corresponding to the plurality of emission areas EA. The removing a portion of the organic insulating material layer M132 may provide solid portions of the pixel defining layer 132 between which are defined pixel openings corresponding to the emission areas EA.

As shown in FIG. 29, the process of providing the pixel defining layer 132 by removing a part of the organic insulating material layer M132 corresponding to the plurality of emission areas EA, may include a process of removing a part of the organic insulating material layer M132 corresponding to the plurality of emission areas EA, using a predetermined etching material.

Alternatively, as shown in FIG. 30, the process of providing the pixel defining layer 132 by removing a part of the organic insulating material layer M132 corresponding to the plurality of emission areas EA may further include a process of removing the residue of the organic insulating material layer M132 remaining on a part of each of the plurality of anode electrodes 131 using oxygen (O₂) plasma after using a predetermined etching material.

Accordingly, the cover layer 1312 of each of the plurality of anode electrodes 131 is not exposed to the etching material of the organic insulating material layer M132, so that damage to the transparent conductive material forming the cover layer 1312 may be reduced.

However, the oxygen content on the surface of the pixel defining layer 132 may increase due to the oxygen (Oz) plasma treatment, so that the oxidation of the second common layer CML2 in contact with the pixel defining layer 132 may be promoted.

To this end, the method for manufacturing the display devices 10a, 10c, and 10d according to the embodiments may further include disposing the gas blocking surfaces GBS and GBS2 on the surface of the pixel defining layer 132 by performing nitrogen (N₂) plasma treatment on the pixel defining layer 132 (S31) after the disposing of the pixel defining layer 132 (S42).

At this time, while the nitrogen (N₂) plasma treatment is being performed, at least a part of each of a carbon-carbon bond (C-C) and a carbon-oxygen bond (C-O, C=O) on the surface of the pixel defining layer 132 is replaced by a carbon-nitrogen-oxygen bond (C-N=O) or a carbon-nitrogen-carbon bond (C=N-C), so that the gas blocking surfaces GBS and GBS2 where the oxygen content is lower by about 20% or more compared to other portions of the pixel defining layer 132 may be provided on the surface of the pixel defining layer 132.

In addition, in consideration of damage to the transparent conductive material forming the cover layer 1312 of each of the plurality of anode electrodes 131, the step of performing nitrogen (N₂) plasma treatment on the pixel defining layer 132 (S31) may be performed with a relatively weak intensity or for a shorter process time compared to the step of performing nitrogen (N₂) plasma treatment on the second planarization layer 122 (S32) and the step of performing nitrogen (N₂) plasma treatment on the first planarization layer 121 (S33).

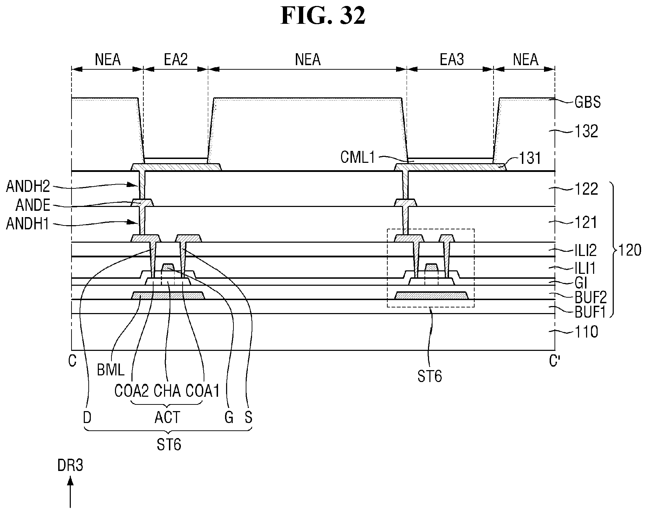

Referring to FIG. 32, the first common layer CML1 is disposed on the plurality of anode electrodes 131 (S43). The plurality of anode electrodes 131 may be exposed to outside the pixel defining layer 132, at the pixel openings thereof.

The disposing of the first common layer CML1 (S43) may include a process of stacking an organic material having a hole transport property on the plurality of anode electrodes 131 in a state where masks corresponding to the plurality of emission areas EA are aligned.

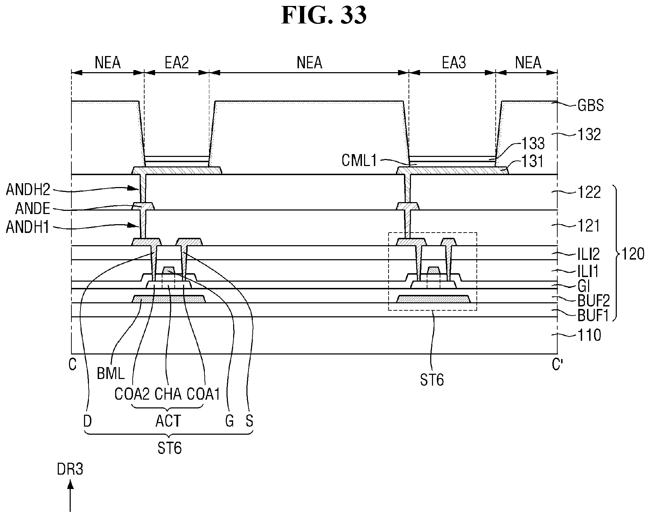

Referring to FIG. 33, the light emitting layer 133 is disposed on the first common layer CML1 (S44).

The disposing of the light emitting layer 133 (S44) may include a process of disposing the light emitting layer of the first emission area EA1, a process of disposing the light emitting layer of the second emission area EA2, and a process of disposing the light emitting layer of the third emission area EA3.

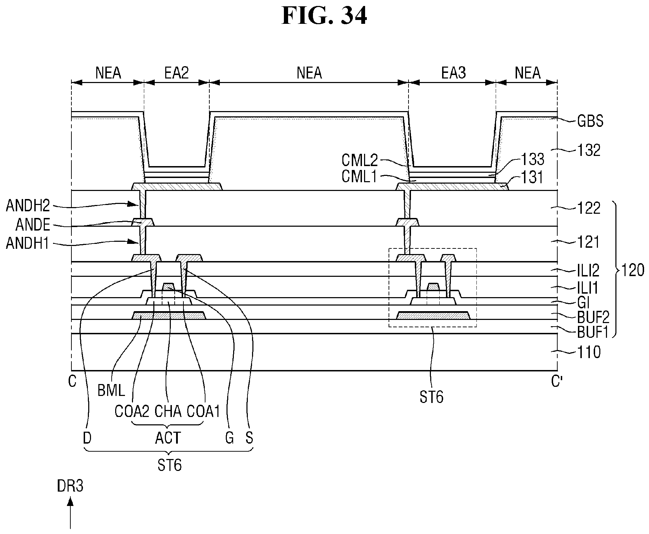

Referring to FIG. 34, the second common layer CML2 is disposed on the pixel defining layer 132 and the plurality of light emitting layers 133 (S45).

The disposing of the second common layer CML2 (S45) may include a process of stacking an organic material having an electron transport property on the pixel defining layer 132 and the plurality of light emitting layers 133, without a mask.

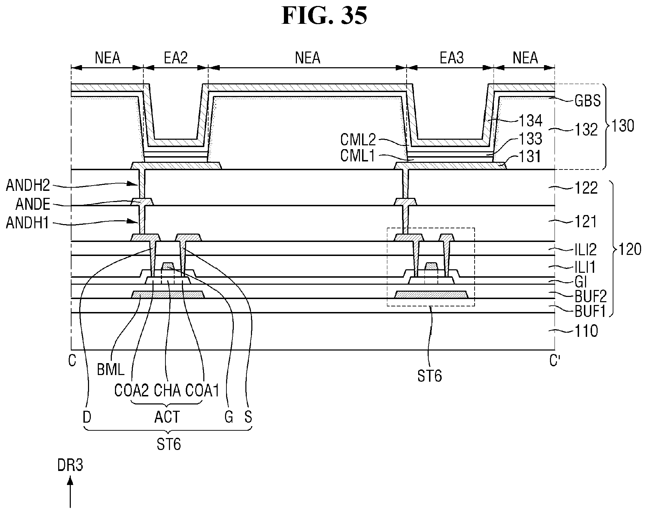

Referring to FIG. 35, the cathode electrode 134 is disposed on the second common layer CML2 (S46).

The cathode electrode 134 may be made of a transparent conductive material (TCO) such as ITO or IZO.

Alternatively, the cathode electrode 134 may be formed of a transparent conductive material (TCO), or a semi-transmissive conductive material such as magnesium (Mg), silver (Ag), or an alloy of magnesium (Mg) and silver (Ag).

Accordingly, the light emitting array layer 130 is provided, including a gas blocking thickness portion.

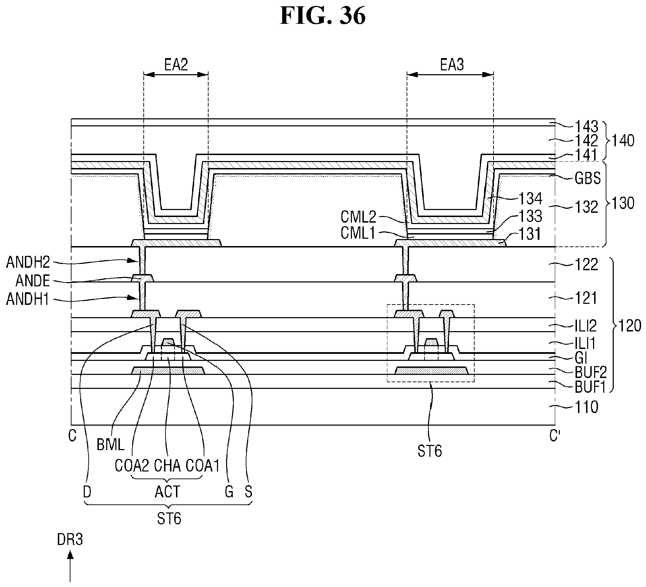

Referring to FIG. 36, the sealing structure 140 for sealing the light emitting array layer 130 is disposed (S50).

The disposing of the sealing structure 140 (S50) may include a process of disposing the first sealing layer 141 made of an inorganic insulating material and covering the light emitting array layer 130 on the circuit array layer 120, a process of disposing the second sealing layer 142 made of an organic insulating material on the first sealing layer 141, and a process of disposing the third sealing layer 143 made of an inorganic insulating material and covering the second sealing layer 142 on the first sealing layer 141.

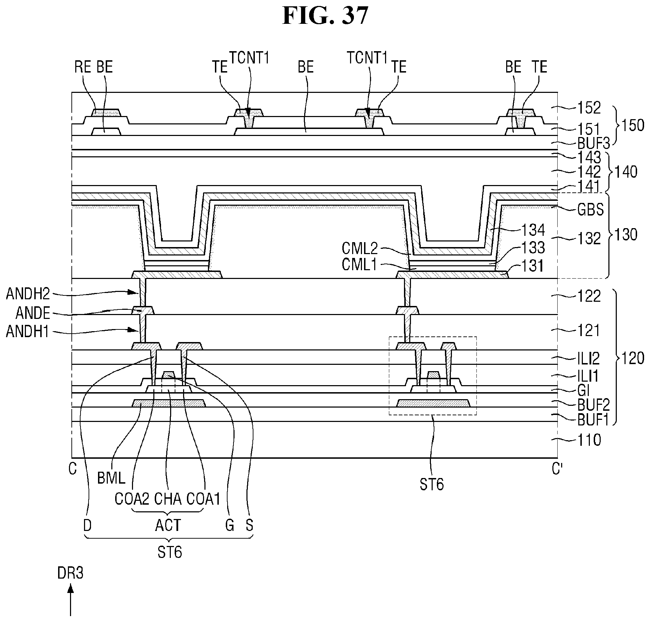

Referring to FIG. 37, the sensor electrode layer 150 is disposed on the sealing structure 140 (S60).

As described above, in accordance with the respective embodiments, the gas barrier layers GBS, GBS1, GBS2, and GBS3 having a relatively low oxygen content as compared to a remainder of a respective organic layer, are disposed extended into the respective organic layer from a top surface thereof. At least one of the first planarization layer 121, the second planarization layer 122 and the pixel defining layer 132 made of an organic insulating material includes such gas blocking thickness portion, so that it is possible to reduce the influence of oxygen, moisture, and gas from the organic insulating material in generating oxidation of the second common layer CML2 and the cathode electrode 134. Accordingly, the luminance and lifespan of the display devices 10a to 10g may be increased.

However, the aspects of the disclosure are not restricted to the one set forth herein. The above and other aspects of the disclosure will become more apparent to one of daily skill in the art to which the disclosure pertains by referencing the claims, with functional equivalents thereof to be included therein.

## Claims

1. A display device comprising:
a substrate comprising a display area including a light emission area, and a non-emission area which is adjacent to the light emission area;
a circuit array layer on the substrate, wherein the circuit array layer comprises:
a pixel driving circuit corresponding to the light emission area;
a first planarization layer on the pixel driving circuit and comprising an organic insulating material;
an anode connection electrode on the first planarization layer and connected to the pixel driving circuit; and
a second planarization layer on the first planarization layer, on the anode connection electrode, and comprising an organic insulating material, and
a light emitting array layer on the circuit array layer, wherein the light emitting array layer comprises:
an anode electrode on the second planarization layer, corresponding to the light emission area, and connected to the anode connection electrode;
a pixel defining layer on the second planarization layer, corresponding to the non-emission area, overlapping an edge of the anode electrode, and comprising an organic insulating material;
a light emitting layer on the anode electrode; and
a cathode electrode on the pixel defining layer and the light emitting layer, and corresponding to the light emission area,
wherein a layer among the first planarization layer, the second planarization layer and the pixel defining layer comprises a gas blocking thickness portion which extends from a surface of the layer which is closest to the cathode electrode.

2. The display device of claim 1, wherein the light emitting array layer further comprises:
a first common layer between the anode electrode and the light emitting layer; and
a second common layer between the light emitting layer and the cathode electrode.

3. The display device of claim 2, wherein the pixel defining layer comprises:
the surface which is closest to the cathode electrode, and
the gas blocking thickness portion is in contact with the second common layer, optionally wherein:
the pixel defining layer further comprises:
a surface which is closest to the substrate, and
oxygen within the gas blocking thickness portion is less than oxygen at the surface which is closest to the substrate.

4. The display device of claim 2, wherein
the anode electrode includes a reflective metal material, and a transparent conductive material which is on the reflective metal material, and
the second planarization layer comprises:
the surface which is closest to the cathode electrode, and
the gas blocking thickness portion which extends from the surface which is closest to the cathode electrode.

5. The display device of claim 4, wherein:
(i) the anode connection electrode is connected to the pixel driving circuit through a first anode contact hole penetrating the first planarization layer,
the anode electrode is connected to the anode connection electrode through a second anode contact hole penetrating the second planarization layer, and
the gas blocking thickness portion is in contact with the anode electrode; and/or
(ii) the second planarization layer further comprises:
a surface which is closest to the substrate, and
oxygen within the gas blocking thickness portion is less than oxygen at the surface which is closest to the substrate.

6. The display device of claim 2, wherein
the gas blocking thickness portion is provided in plural including a first gas blocking thickness portion and a second gas blocking thickness portion,
the second planarization layer comprises:
a first surface which is closest to the cathode electrode,
the first gas blocking thickness portion extending from the first surface,
a second surface which is closest to the substrate, and
oxygen within the first gas blocking thickness portion is less than oxygen at the second surface of the second planarization layer which is closest to the substrate, together with the pixel defining layer comprising:
a third surface which is closest to the cathode electrode,
the second gas blocking thickness portion extending from the third surface,
a fourth surface which is closest to the substrate, and
oxygen within the second gas blocking thickness portion is less than oxygen at the fourth surface of the pixel defining layer which is closest to the substrate.

7. The display device of claim 6, wherein:
(i) the second gas blocking thickness portion is closer to the cathode electrode than the first gas blocking thickness portion, and
a thickness of the second gas blocking thickness portion is smaller than a thickness of the first gas blocking thickness portion; and/or
(ii) the gas blocking thickness portion which is provided in plural further includes a third gas blocking thickness portion, and
the first planarization layer comprises:
a fifth surface which is closest to the cathode electrode,
the third gas blocking thickness portion extending from the fifth surface,
a sixth surface which is closest to the substrate, and
oxygen within the third gas blocking thickness portion is less than oxygen at the sixth surface of the first planarization layer which is closest to the substrate.

8. The display device of any one of claims 2 to 7, wherein
the pixel driving circuit includes a transistor, the transistor comprising a semiconductor layer on the substrate, a gate electrode, and a gate insulating layer between the semiconductor layer and the gate electrode, and
the pixel driving circuit further includes an interlayer insulating layer facing the substrate with the transistor therebetween.

9. The display device of any one of claims 2 to 7, wherein
the pixel driving circuit includes a first transistor and a second transistor,
the first transistor comprises a first semiconductor layer on the substrate and comprising a silicon semiconductor, a first gate electrode, and a first gate insulating layer between the first semiconductor layer and the first gate electrode,
the second transistor comprises a second semiconductor layer in a different layer than the first semiconductor layer and comprising an oxide semiconductor, a second gate electrode, and a second gate insulating layer between the second semiconductor layer and the second gate electrode, and
the first planarization layer faces the substrate, with each of the first and second semiconductor layers, the first and second gate electrodes and the first and second gate insulating layers therebetween.

10. The display device of claim 9, wherein
the display area further includes:
the light emission area provided in plural including a first emission area, a second emission area and a third emission area which emit different colors from each other,
a plurality of pixels each including the first, second and third emission areas, and
a boundary between adjacent pixels among the plurality of pixels, and
the circuit array layer further comprises:
the second gate electrode furthest from the substrate among the first and second semiconductor layers, the first and second gate electrodes and the first and second gate insulating layers,
a groove corresponding to the boundary between the adjacent pixels,
an auxiliary planarization layer between the second gate electrode and the first planarization layer, the auxiliary planarization layer comprising an organic insulating material, and
the auxiliary planarization layer extending from between the second gate electrode and the first planarization layer, into the groove, and contacting the substrate at the groove, optionally wherein:
the auxiliary planarization layer comprises:
the surface which is closest to the cathode electrode, and
the gas blocking thickness portion which extends from the surface which is closest to the cathode electrode.

11. A method for providing a display device, comprising:
providing a substrate comprising a display area including a light emission area, and a non-emission area which is adjacent to the light emission area;
providing, on the substrate, a pixel driving circuit corresponding to the light emission area;
providing a first planarization layer on the pixel driving circuit and comprising an organic insulating material;
providing, on the first planarization layer, an anode connection electrode connected to the pixel driving circuit;
providing, on the first planarization layer, a second planarization layer on the anode connection electrode and comprising an organic insulating material;
providing, on the second planarization layer, an anode electrode corresponding to the light emission area and connected to the anode connection electrode;
providing, on the second planarization layer, a pixel defining layer corresponding to the non-emission area, overlapping an edge of the anode electrode, and comprising an organic insulating material;
providing a light emitting layer corresponding to the light emission area, on the anode electrode;
providing a cathode electrode corresponding to the light emission area, on the pixel defining layer and the light emitting layer; and
providing for a layer among the first planarization layer, the second planarization layer and the pixel defining layer, a gas blocking thickness portion which extends from a surface of the layer which is closest to the cathode electrode,
wherein the providing of the gas blocking thickness portion includes providing nitrogen plasma treatment to the layer.

12. The method of claim 11,
further comprising, before the providing of the light emitting layer, providing a first common layer comprising a hole transport layer comprising an organic material having a hole transport property, on the anode electrode, and
further comprising, before the providing of the cathode electrode, providing a second common layer comprising an electron transport layer comprising an organic material having an electron transport property, on the pixel defining layer and the light emitting layer.

13. The method of claim 12, wherein
the providing of the pixel defining layer comprises providing an organic insulating material layer on the anode electrode and on the second planarization layer, and removing a part of the organic insulating material layer corresponding to the light emission area,
after the providing of the pixel defining layer, the nitrogen plasma treatment is performed to provide a first gas blocking thickness portion extended from a surface of the pixel defining layer which is closest to the cathode electrode, and
in the providing of the second common layer, the second common layer is in contact with the first gas blocking thickness portion of the pixel defining layer.

14. The method of claim 13, wherein
the organic insulating material layer includes a carbon-carbon bond and a carbon-oxygen bond, and
in the performing of the nitrogen plasma treatment after the providing of the pixel defining layer, the surface of the pixel defining layer is exposed to the nitrogen plasma treatment, and a part of each of the carbon-carbon bond and the carbon-oxygen bond at the surface of the pixel defining layer is replaced by a carbon-nitrogen-oxygen bond, to provide the first gas blocking thickness portion at the surface of the pixel defining layer.

15. The method of claim 14, wherein:
(i) the first gas blocking thickness portion of the pixel defining layer includes less oxygen than a surface of the pixel defining layer which is in contact with the second planarization layer; and/or
(ii) the providing of the pixel defining layer by removing the part of the organic insulating material layer which corresponds to the light emission area comprises:
removing a portion of the part of the organic insulating material layer which corresponds to the light emission area, by using an etching material; and
removing a residue of the organic insulating material layer remaining on the anode electrode, by using oxygen plasma.

16. The method of claim 12, wherein the anode electrode includes a reflective metal material and a transparent conductive material.

17. The method of claim 16, wherein in the providing of the second planarization layer, the second planarization layer comprises an organic insulating material including a carbon-carbon bond and a carbon-oxygen bond,
the method further comprising, after the providing of the first planarization layer, providing a first anode contact hole corresponding to the pixel driving circuit and penetrating the first planarization layer,
the method further comprising, after the providing of the second planarization layer,
providing a second anode contact hole corresponding to the anode connection electrode and penetrating the second planarization layer; and
providing a first gas blocking thickness portion at a surface of the second planarization layer which is closest to the cathode electrode, by performing the nitrogen plasma treatment at the surface of the second planarization layer.

18. The method of claim 17, wherein:
(i) in the performing of the nitrogen plasma treatment at the surface of the second planarization layer, a part of each of the carbon-carbon bond and the carbon-oxygen bond on the surface of the second planarization layer is replaced by a carbon-nitrogen-oxygen bond by the nitrogen plasma treatment, to provide the first gas blocking thickness portion at the surface of the second planarization layer; and/or
(ii) the first gas blocking thickness portion of the second planarization layer includes less oxygen than a surface of the second planarization layer which is in contact with the first planarization layer; and/or
(iii) after the providing of the pixel defining layer, the first gas blocking thickness portion of the second planarization layer is in contact with the anode electrode and the pixel defining layer.

19. The method of claim 17 or claim 18, wherein the providing of the pixel defining layer comprises:
providing an organic insulating material layer on the anode electrode and on the second planarization layer;
removing a part of the organic insulating material layer on the second planarization layer which corresponds to the light emission area; and
providing a second gas blocking thickness portion at a surface of the pixel defining layer which is closest to the cathode electrode, by performing the nitrogen plasma treatment at the surface of the pixel defining layer,
wherein in the providing of the second common layer, the second common layer is in contact with the second gas blocking thickness portion of the pixel defining layer.

20. The method of claim 19, wherein:
(i) the second gas blocking thickness portion of the pixel defining layer includes less oxygen than a surface of the pixel defining layer which is in contact with the second planarization layer; and/or
(ii) the first planarization layer, the second planarization layer and the pixel defining layer are in order from the substrate, and
a thickness of the second gas blocking thickness portion of the pixel defining layer is smaller than a thickness of the first gas blocking thickness portion of the second planarization layer; and/or
(iii) the method further comprises, after the providing of the first planarization layer,
providing the first anode contact hole; and
providing a third gas blocking thickness portion at a surface of the first planarization layer which is closest to the cathode electrode, by performing the nitrogen plasma treatment at the surface of the first planarization layer.
